Europäisches Patentamt

European Patent Office

Office européen des brevets

(19)

(11) **EP 1 263 100 A2**

(12) # EUROPEAN PATENT APPLICATION

(43) Date of publication:
**04.12.2002 Bulletin 2002/49**

(51) Int Cl.⁷: **H01S 5/32**

(21) Application number: **02011749.5**

(22) Date of filing: **27.05.2002**

| | |
|---|---|
| (84) Designated Contracting States:<br>**AT BE CH CY DE DK ES FI FR GB GR IE IT LI LU MC NL PT SE TR**<br>Designated Extension States:<br>**AL LT LV MK RO SI**<br><br>(30) Priority: **28.05.2001 JP 2001158404**<br>**07.06.2001 JP 2001172610**<br>**27.08.2001 JP 2001256234**<br><br>(71) Applicant: **Fuji Photo Film Co., Ltd.**<br>**Kanagawa-ken (JP)** | (72) Inventors:<br>• **Fukunaga, Toshiaki, Fuji Photo Film Co.,Ltd.**<br>  **Ashigarakami-gun, Kanagawa-ken (JP)**<br>• **Ohgoh, Tsuyoshi, Fuji Photo Film Co.,Ltd.**<br>  **Ashigarakami-gun, Kanagawa-ken (JP)**<br><br>(74) Representative: **Klunker . Schmitt-Nilson . Hirsch**<br>**Winzererstrasse 106**<br>**80797 München (DE)** |

(54) **Semiconductor laser device and method of manufacture thereof**

(57)     Heating at the end face while operating in a high output is prevented and reliability improves in a semiconductor laser device. On an n-GaAs substrate 101, laminated are an n-GaAlAs cladding layer 102, an n- or i-InGaP lower optical waveguide layer 103, an i-InGaAsP lower barrier layer 104, an InGaAsP compressive strain quantum well active layer 105, a p- or i-InGaAsP upper barrier layer 106, an InGaP cap layer 107 with a thickness of about 10nm. Regions of the cap layer 107, the upper barrier layer 106, the active layer 105 and the lower barrier layer 104, the regions being in the vicinity of end faces thereof adjacent to resonator end faces are removed. An InGaP upper optical waveguide layer 108 with a band gap larger than that of the active layer 105 is formed on the InGaP cap layer and the removed portions in the vicinity of the end faces. Moreover, a cladding layer 120 of a second conductive type is formed on the upper optical waveguide layer 108.

# FIG.1A

EP 1 263 100 A2

**Description**

BACKGROUND OF THE INVENTION

Field of the Invention

The present invention relates to a semiconductor laser device and more particularly to a semiconductor laser device comprising an InGaAs or InGaAsP active layer with compressive strain on a GaAs substrate.

Description of the Related Art

In many conventional semiconductor laser devices which emit laser light having a wavelength of 0.7 to 1.2 $\mu$m, a current confinement structure and an index-guided structure are provided in crystal layers constituting each semiconductor laser device so that each semiconductor laser device oscillates in a fundamental transverse mode.

For example, J. K. Wade et al. ("6.1W continuous wave front-facet power from Al-free active-region ($\lambda$ =805 nm) diode lasers," Applied Physics Letters, vol. 72, No. 1, 1998, pp.4-6) disclose a semiconductor laser device which emits light in the 805 nm band. The semiconductor laser device comprises an Al-free InGaAsP active layer, an InGaP optical waveguide layer, and InAlGaP cladding layers. In addition, in order to improve the characteristics in the high output power range, the semiconductor laser device includes a so-called large optical cavity (LOC) structure in which the thickness of the optical waveguide layer is increased so as to reduce the peak power density, and increase the maximum optical output power. However, when the optical power is maximized, currents generated by optical absorption in the vicinity of end faces generate heat, i.e., raise the temperature at the end faces. In addition, the raised temperature reduces the band gaps at the end faces, and therefore the optical absorption is further enhanced to damage the end face. That is, a vicious cycle is formed. This damage is the so-called catastrophic optical mirror damage (COMD). When the optical power reaches the COMD level, the optical output deteriorates with time. Further, the semiconductor laser device is likely to suddenly break down due to the COMD. Therefore, the above semiconductor laser device is not reliable when the semiconductor laser device operates with high output power.

Further, T. Fukunaga et al. ("Highly Reliable Operation of High-Power InGaAsP/InGaP/AlGaAs 0.8 $\mu$ m Separate Confinement Heterostructure Lasers," Japanese Journal of Applied Physics, vol. 34 (1995) L1175-L1177) disclose a semiconductor laser device which comprises an Al-free active layer, and emits light in the 0.8 $\mu$m band. In the semiconductor laser device, an n-type AlGaAs cladding layer, an intrinsic (i-type) In-GaP optical waveguide layer, an InGaAsP quantum well active layer, an i-type InGaP optical waveguide layer, a p-type AlGaAs cladding layer, and a p-type GaAs cap layer are formed on an n-type GaAs substrate. However, the maximum optical output power of the semiconductor laser device is typically 1.8 W, i.e., low.

Moreover, in "High-Power Highly-reliable Operation of 0.98-$\mu$m InGaAs-InGaP Strain-Compressed Single-Quantum-Well Lasers with Tensile-Strained InGaAsP Barriers.: IEEE Journal of Selected Topics in Quantum Electronics, Vol. 1, No. 2 (1995) pp. 189." (hereinafter referred to as document 1), as an all Al-free semiconductor laser device with a wavelength of 0.98 $\mu$m, there is reported a semiconductor laser device, which is provided with a current confinement layer and a refractive index waveguide mechanism and which oscillates in a fundamental transverse mode, wherein on an n-type GaAs substrate, laminated are an n-type In-GaP cladding layer, an InGaAsP optical waveguide layer of an undoped type, a tensile-stained InGaAsP barrier layer, an InGaAs double quantum well active layer, a tensile-stained InGaAsP barrier layer, an InGaAsP optical waveguide layer of an undoped type, a p-type In-GaP upper first cladding layer, a p-type GaAs optical waveguide layer, a p-type InGaP upper second cladding layer, a p-type GaAs cap layer and an insulation layer so as to form a narrow-stripped ridge structure up to the upper portion of the p-type InGaP upper first cladding layer by selective etching with general photolithography, and both sides of the ridge structure is buried with n-type $In_{0.5}Ga_{0.5}P$ by selective MOCVD growth to remove the insulation layer so as to form a p-type GaAs contact layer.

However, in the semiconductor laser device reported in document 1, a characteristic temperature of a threshold current is as low as 156K, causing difficulty in reducing costs since temperature adjustment is essential to practical use. The reason why the temperature characteristic of this semiconductor layer device is low is largely attributed to influence due to carrier overflow. The carrier overflow is a phenomenon in which the density of carrier injection to the active layer is increased by high power and a high-temperature operation, so that the carrier overflows from the active layer area onto the optical waveguide layer and cladding layer area. Particularly, in the case of document 1, there has been a drawback in which the structure causes the carrier overflow easily since a band gap difference between the active layer and the optical waveguide layer is small.

In order to solve this problem, there has been proposed a semiconductor laser device using $In_{0.49}Ga_{0.51}P$ as an optical waveguide layer and $Al_{z1}Ga_{1-z1}As$ cladding layer ($0.6 \leq z1 \leq 0.8$) as a cladding layer in Japanese Unexamined Patent Publication No. 2001-168458. The adoption of $In_{0.49}Ga_{0.51}P$ with a large band gap as an optical waveguide layer suppresses the leakage of carriers from the active layer and a value of a characteristic temperature $T_0$ reaches 300K or more, a large improvement in the temperature characteristic can be seen. Moreover, in the aforementioned publication, as an example that is applied to a single mode LD, there is disclosed the structure in which $In_{0.49}(Al_{z2}Ga_{1-z2})_{0.51}P$ ($0.15 \leq z2 \leq 1$) is used as a current confinement layer and this makes it possible to obtain a single mode LD with a good temperature characteristic. However, in $In_{0.49}(Al_{z2}Ga_{1-z2})_{0.51}P$ with high Al composition, there were problems such as deterioration in characteristics, a reduction in yield, etc., resulting from the fact that a good quality crystal was not easily obtained. Accordingly, the aforementioned semiconductor laser device still had room for improvement.

Meanwhile, in Japanese Unexamined Patent Publication No. 2001-148541, in order to improve noise characteristics of a semiconductor laser device, there has been proposed the structure wherein in the semiconductor laser device using $In_{x1}Ga_{1-x1}As_{1-y1}P_{y1}$ as a quantum well active layer and $In_{0.49}Ga_{0.51}P$ as an optical waveguide layer, an $In_{0.49}Ga_{0.51}P$ upper first optical waveguide layer, a GaAs etching stop layer, an $In_{0.49}(Al_{z2}Ga_{1-z2})_{0.51}P$ current confinement layer, and a $In_{0.49}Ga_{0.51}P$ cap layer are laminated as a layer structure on the quantum well active layer, thereafter the $In_{0.49}Ga_{0.51}P$ cap layer of a stripe region where a current is injected, the $In_{0.49}(Al_{z2}Ga_{1-z2})_{0.51}P$ current confinement layer, and the GaAs etching stop layer are removed to expose the $In_{0.49}Ga_{0.51}P$ upper first optical waveguide layer, and two layers of an $In_{0.49}Ga_{0.51}P$ upper second optical waveguide layer and an $Al_{z1}Ga_{1-z1}As$ upper cladding layer ($0.57 \leq z1 \leq 0.8$) are laminated on the cap layer and the upper first optical waveguide layer.

The semiconductor laser device having the aforementioned structure has an advantage in that not only a noise characteristic is improved but also the Al composition of $In_{0.49}(Al_{z2}Ga_{1-z2})_{0.51}P$, which is the current confinement layer, can be reduced as compared with the semiconductor laser device disclosed in the above-mentioned Japanese Unexamined Patent Publication No. 2001-168458. However, there was still more room for improvement to suppress catastrophic optical mirror damage (COMD) under a high power drive condition even with the elimination of the problem resulting from the high Al composition.

SUMMARY OF THE INVENTION

In consideration of the aforementioned problem, it is an object of the present invention to provide a semiconductor laser device, which suppresses the occurrence of COMD and which is excellent in reliability under a high power drive condition, in a semiconductor laser device comprising an $In_{x1}Ga_{1-x1}As_{1-y1}P_{y1}$ active layer with compressive strain, and a method for manufacturing the same.

According to a first aspect of the present invention, there is provided a semiconductor laser device comprising: a GaAs substrate of a first conductive type; and a semiconductor layer formed on the GaAs substrate, the semiconductor layer including: a cladding layer of a first conductive type, formed on the GaAs substrate; a lower optical waveguide layer made of InGaP of the first conductive type or an undoped type, the lower optical wavelength layer being formed on the lower cladding layer; a compressive strain active layer made of InGaAsP or InGaAs, the compressive strain active layer being formed on the lower optical waveguide layer; an upper optical waveguide layer made of InGaP of a second conductive type or an undoped type, the upper optical waveguide layer being formed on the compressive strain active layer; and a cladding layer of the second conductive type.

Here, the semiconductor laser device according to the first aspect of the present invention is characterized in that: an InGaAsP lower barrier layer is provided between the lower optical waveguide layer and the compressive strain active layer, the InGaAsP lower barrier layer having a band gap larger than that of the compressive strain active layer; an InGaAsP upper barrier layer is provided between the compressive strain active layer and the upper optical waveguide layer, the InGaAsP lower barrier layer having a band gap larger than that of the compressive strain active layer; portions of the lower barrier layer, the compressive strain active layer and the upper barrier layer are removed, which are adjacent to two opposite end faces constituting a resonator end face among end faces obtained by cleaving the semiconductor layer; the lower and upper optical waveguide layers have band gaps larger than that of the compressive strain active layer; and the upper optical waveguide layer is buried in the removed portions of the lower barrier layer, the compressive strain active layer and the upper barrier layer.

Preferably, the semiconductor laser device according to the present invention may also have one or any possible combination of the following additional features (i) to (vii).

(i) The compressive strain active layer should be made of $In_{x3}Ga_{1-x3}As_{1-y3}P_{y3}$, where $0.49y3 < x3 \leq 0.4$ and $0 \leq y3 \leq 0.1$. Note that when y3=0 is satisfied, InGaAs containing no phosphorus is used.

(ii) The InGaAsP lower and upper barrier layers may have a compressive strain and a tensile strain, and the InGaAsP lower and upper barrier layers may be lattice-matched to each other. Note that an absolute value of a sum of products of strain quantities and film thickness of the InGaAsP lower and upper barrier layers shall be set to 0.3 nm or less.

(iii) A contact layer of the second conductive type should be formed in a region on the second cladding layer part, the region excluding a region corresponding to the portions where the lower barrier layer, the compressive strain active layer and the upper barrier layer are removed; and an insulating film should be formed in a region on the second cladding layer part, the region corresponding to the portions where the lower barrier layer, the compressive strain active layer and the upper barrier layer are removed.

(iv) A ridge portion may be provided, which is formed by removing both sides of a stripe-shaped portion of the cladding layer part of the second conductive type, the stripe-shaped portion extending from one resonator end face to the other resonator end face, from an upper surface of the cladding layer part of the second conductive type to a predetermined position.

(v) The cladding layer part of the second conductive type may be composed of one layer, or alternatively the cladding layer part may be composed of a plurality of layers For example, the cladding layer part of the second conductive type may comprise a first cladding layer of the second conductive type formed on the upper optical waveguide layer; a first etching stop layer made of InGaP of the second conductive type and being formed on the first cladding layer; a second etching stop layer made of GaAs having a stripe-shaped current injection opening extending from one resonator end face to the other resonator end face and being formed on the first etching stop layer; a current confinement layer made of InGaAlP of the first conductive type having a stripe-shaped current injection opening extending from one resonator end face to the other resonator end face and being formed on the second etching stop layer; a cap layer made of InGaP of the first conductive type having a stripe-shaped current injection opening extending from one resonator end face to the other resonator end face and being formed on the current confinement layer; and a second cladding layer of the second conductive type and being formed on the cap layer. Alternatively, the cladding layer part of the second conductive type may comprise an etching stop layer made of GaAs having a stripe-shaped current injection opening extending from one resonator end face to the other resonator end face and being formed on the upper optical waveguide layer; a current confinement layer of the first conductive type made of InGaAlP having a stripe-shaped current injection opening extending from one resonator end face to the other resonator end face and being formed on the etching stop layer; a cap layer of the first conductive type made of InGaP having a stripe-shaped current injection opening extending from one resonator end face to the other resonator end face and being formed on the current confinement layer; and a cladding layer of the second conductive type being formed on the cap layer.

(vi) In the second semiconductor laser device of the present invention, each of the cladding layers should be made of one of AlGaAs, InGaAlP and InGaAlAsP which are lattice-matched with the GaAs substrate.

(vii) The lower and upper barrier layers may be respectively composed of one layer of $In_{x1}Ga_{1-x1}As_{1-y1}P_{y1}$ where $0 \leq x1 \leq 0.3$ and $0 \leq y1 \leq 0.6$, or composed of two layers of $In_{x2}Ga_{1-x2}As_{1-y2}P_{y2}$ where $0 \leq x2 \leq 0.3$ and $x2 = 0.49y2$ and a tensile strain barrier layer made of $In_{x4}Ga_{1-x4}As_{1-y4}P_{y4}$ where $0.49y > x4 \geq 0$ and $0 < y4 \leq 0.5$, and the tensile strain barrier layer is disposed so as to be adjacent to the compressive strain active layer.

A method of manufacturing a semiconductor laser device according to a second aspect of the present invention in which a plurality of semiconductor layers including a compressive strain active layer are laminated on a substrate and a resonator end face is constituted by two opposite end faces, comprises the steps of: forming a cladding layer of a first conductive type on a GaAs substrate of the first conductive type; forming an InGaP lower optical waveguide layer of the first conductive type or an undoped type on the cladding layer, the lower optical waveguide layer having a band gap larger than that of the compressive strain active layer; forming an InGaAsP lower barrier layer on the lower optical waveguide layer, the lower barrier layer having a band gap larger than that of the compressive strain active layer; forming the compressive strain active layer made of one of InGaAsP and InGaAs on the lower barrier layer; forming an InGaAsP upper barrier layer on the compressive strain active layer, the upper barrier layer having a band gap larger than that of the compressive strain active layer; forming an InGaP cap layer on the upper barrier layer; forming a GaAs cap layer on the cap layer; removing a portion of the GaAs cap layer in the vicinity of an end face adjacent to the resonator end face; removing a portion of the InGaP cap layer in the vicinity of the end face using the GaAs cap layer as a mask; removing the GaAs cap layer used as the mask and simultaneously removing portions in the vicinity of the end faces of the upper barrier layer, the compressive strain active layer and the lower barrier layer using the InGaP cap layer as a mask; forming an InGaP upper optical waveguide layer of a second conductive type or an undoped type having a band gap larger than that of the compressive strain active layer on the removed portions in the vicinity of the end face and the InGaP cap layer; and forming a cladding layer of the second conductive type on the upper optical waveguide layer.

Here, the cladding layer of the second conductive type is formed by the steps of: laminating a first cladding layer of the second conductive type on the upper optical waveguide layer; laminating a first etching stop layer made of InGaP of the second conductive type on the first cladding layer; laminating a second etching stop layer made of GaAs on the first etching stop layer; laminating an InGaAlP current confinement layer of the first conductive type on the second etching stop layer; laminating an InGaP cap layer of the first conductive type on the current confinement layer; laminating a second GaAs cap layer on the InGaP cap layer; removing a portion of the second GaAs cap layer corresponding to a stripe-shaped current injection opening; removing portions of the InGaP cap layer of the first conductive type and the current confinement layer, the portions being used as the current injection opening, using the second GaAs cap layer as a mask; removing the second GaAs cap layer used as the mask and simultaneously moving a portion of the second etching stop layer, the portion being used as the current injection opening, using the InGaP cap layer of the first conductive type as a mask; and forming a second cladding layer of the second conductive type so as to cover the current injection opening.

Alternatively, the cladding layer part of the second conductive type may be formed by the steps of: laminating a GaAs etching stop layer on the upper optical waveguide layer; laminating an InGaAlP current confinement layer of the first conductive type on the second GaAs etching stop layer; laminating an InGaP cap layer of the first conductive type on the current confinement layer; laminating a second GaAs cap layer on the InGaP cap layer; removing a portion of the second GaAs cap layer corresponding to a stripe-shaped current injection opening; removing portions of the InGaP cap layer of the first conductive type and the current confinement layer, the portions being used as the current injection opening, using the second GaAs cap layer as a mask; removing the second GaAs cap layer used as the mask and simultaneously removing a portion of the GaAs etching stop layer, the portion being used as the current injection opening, using the InGaP cap layer as a mask; and forming a cladding layer of the second conductive type so as to cover the current injection opening.

According to a third aspect of the present invention, there is provided a semiconductor laser device comprising: a GaAs substrate of a first conductive type; a lower cladding layer of the first conductive type, the lower cladding layer being formed on the GaAs substrate; a lower optical waveguide layer of the first conductive type or an undoped type made of InGaP, the lower optical waveguide layer being lattice-matched with the GaAs substrate and formed on the lower cladding layer; an active layer made of $In_{x1}Ga_{1-x1}As_{1-y1}P_{y1}$ with compressive strain where $0<x1\leq0.4$ and $0\leq y1\leq0.1$, the active layer being formed on the lower optical waveguide layer; an upper first optical waveguide layer of a second conductive type or an undoped type made of InGaP, the upper first optical waveguide layer being lattice-matched with the GaAs substrate and formed on the active layer; a current confinement layer of a first conductive type made of $In_{0.49}(Al_{z2}Ga_{1-z2})_{0.51}P$, the current confinement layer having an opening serving as a current passage and being formed on the upper first optical waveguide layer; an upper second optical waveguide layer of the second conductive type formed so as to bury the opening, the upper second optical waveguide layer being formed on the current confinement layer; an upper cladding layer of the second conductive type, the upper cladding layer being formed on the upper second optical waveguide layer; a GaAs contact layer of the second conductive type, the GaAs contact layer being formed on the upper cladding layer; an electrode formed on the GaAs contact layer; and resonator end faces formed of two opposite end faces, wherein a current injection control structure that controls a current injection to the active layer is provided in the vicinity of at least one of the end faces.

"One electrode" indicates one of a pair of electrodes that the semiconductor laser device generally includes.

The current injection control structure may be formed by providing the GaAs contact layer to extend inwardly from a position away from the one end face by 5 μm or more. Alternatively, the current injection control structure may be formed by providing the GaAs contact layer to extend inwardly from a position away from the one end face by 5 μm or more, providing the electrode having a portion on the contact layer, the portion projecting to the end face from the contact layer, and providing an insulation layer between the projected portion of the electrode and the cladding layer of the second conductive type.

Note that, though the current injection control structure may be formed on at least one of the resonator end faces, it is preferably formed on both faces.

Moreover, it is preferable that the active layer is laminated only inwardly from a position away from at least one of the end faces by a predetermined distance and that a layer which has a band gap larger than that of the active layer, the layer being equivalent to the upper first optical waveguide layer, is laminated on a region ranging from an end edge of the active layer away from the end face to the end face. In other words, provision of the so-called window structure wherein a region where no active layer exists in the portion in the vicinity of at least one end face of the resonator end faces and this region is buried with the layer equivalent to the upper first optical waveguide layer is preferable.

Though the window structure may be formed on at least one of the resonator end faces, it is preferably formed on both faces.

Hereinafter, "a layer, which is equivalent to the upper first optical waveguide layer" means a layer, which is made of InGaP and which is lattice-matched with the GaAs substrate, similar to the upper first optical waveguide layer.

According to a fourth aspect of the present invention, there is provided a semiconductor laser device comprising: a GaAs substrate of a first conductive type; a lower cladding layer of the first conductive type, the lower cladding layer being formed on the GaAs substrate; a lower optical waveguide layer of the first conductive type or an undoped type made of InGaP, the lower optical waveguide layer being lattice-matched with the GaAs substrate and formed on the lower cladding layer; an active layer made of $In_{x1}Ga_{1-x1}As_{1-y1}P_{y1}$ with compressive strain where $0<x1\leq0.4$ and $0\leq y1\leq0.1$, the active layer being formed on the lower optical waveguide layer; an upper first optical waveguide layer of a second conductive type or an undoped type made of InGaP, the upper first optical waveguide layer being lattice-matched with the GaAs substrate and formed on the active layer; a current confinement layer made of $In_{0.49}(Al_{z2}Ga_{1-z2})_{0.51}P$ of a first conductive type, the current confinement layer having an opening serving as a current passage and being formed on the upper first optical waveguide layer; an upper second optical waveguide layer of the second conductive type formed so as to bury the opening, the upper second optical waveguide layer being formed on the current confinement layer; an upper cladding layer of the second conductive type, the upper cladding layer being formed on the upper second optical waveguide layer; a GaAs contact layer of the second conductive type, the GaAs contact layer being formed on the upper cladding layer; an electrode formed on the GaAs contact layer; and resonator end faces formed of two opposite end faces, wherein the active layer is laminated only inwardly from a position away from at least one of the end faces by a predetermined distance, and a layer which has a band gap larger than that of the active layer, the layer being equivalent to the upper first optical waveguide layer, is laminated on a region ranging from an end edge of the active layer away from the end face to the end face.

Namely, the feature of the semiconductor laser device of the present invention lies in the provision of the so-called window structure wherein a region where no active layer exists in the portion in the vicinity of at least one end face of the resonator end faces in the semiconductor laser device having the above-described layer structure and this region is buried with the layer equivalent to the upper first optical waveguide layer. Though this window structure may be formed on at least one of the resonator end faces, it is preferably formed on both faces.

In the semiconductor laser, each of the cladding layers is preferably made of any one of $Al_{z1}Ga_{1-z1}As$ where $0.57\leq z1\leq0.8$ and $In_{0.49}(Ga_{1-z4}Al_{z4})_{0.51}P$ where $0.1\leq z4\leq0.5$.

The upper second optical waveguide layer of the second conductive type is preferably made of any one of InGaP and AlGaAs having a refractive index equivalent to that of the InGaP, which are lattice-matched with the GaAs substrate.

The semiconductor laser devices according to the present invention may comprise barrier layers with a thickness of 10mm or less made of $In_{x3}Ga_{1-x3}As_{1-y3}P_{y3}$ where $0\leq x3\leq0.3$ and $0.1\leq y3\leq0.6$, the barrier layers being severally formed between the active layer and the lower optical waveguide layer and between the active layer and the upper first optical waveguide layer and having band gaps larger than that of the active layer.

Moreover, the semiconductor laser devices according to the present invention may comprise a strain compensation layer made of $In_{x2}Ga_{1-x2}As_{1-y2}P_{y2}$ where $0\leq x2<0.49y2$ and $0<y2\leq0.5$, the strain compensation layer being formed between the active layer and the barrier layer, and having tensile strain stress.

An oscillation peak wavelength is preferably in a range from 900 to 1200 nm.

When a width of the current passage is 1.5 $\mu$m or more and less than 4 $\mu$m, a refractive index step difference is preferably in a range from $1.5 \times 10^{-3}$ to $7.0 \times 10^{-3}$.

When a width of the current passage is 4 $\mu$m or more, a refractive index step difference is preferably $1.5 \times 10^{-3}$ or more.

Regarding the equivalent refractive index step difference, in the case of the device including the internal current confinement structure as in the semiconductor laser device of the present invention, the equivalent refractive index step difference $\Delta$n is defined by nb-na, where na is an equivalent refractive index with an oscillation wavelength in the lamination direction of the region where the current confinement layer exists and nb is an equivalent refractive index with an oscillation wavelength in the lamination direction at the current passage.

The semiconductor laser device according to the first aspect of the present invention adopts the structure (a so called window structure), in which the InGaAsP lower barrier layers having a band gap larger than that of the compressive strain active layer are provided between the lower optical waveguide layer and the compressive strain active layer as well as between the compressive strain active layer and the upper optical waveguide layer, the portions adjacent to the two opposite end faces that constitute the resonator end faces among the end faces obtained by cleaving the semiconductor layer are removed, and the upper optical waveguide layer having a band gap larger than that of the active layer is buried in the removed portions. Since a transparent region for oscillation light can be formed in the vicinity of the end face, it is possible to reduce current generated by light absorption at the end face. Thus, heat generation of the device at the end face can be decreased, and a breakdown level of the end face due to thermal runway generated in the end face can be significantly improved. Accordingly, the present invention can provide a semiconductor laser device with high reliability even when the semiconductor laser device is operated with high output power.

Furthermore, when the InGaAsP barrier layer is not provided between the InGaP optical waveguide layer and the InGaAsP compressive strain active layer, it would generally require a long time for switching gas from P to As, and substitution of P with As occurs at the interface, resulting in deterioration of the quality at the interface, that is, deterioration of the quality of the active layer. However, since the InGaAsP barrier layer is provided in the present invention, switching of gas can be performed smoothly, and the quality of the active layer can be improved. Note that if the InGaAsP barrier layer has tensile strain, there is an advantage that a temperature characteristic of the element can be improved.

The contact layer of the second conductive type is formed in a region on the cladding layer of the second conductive type, the region excluding a region corresponding to the portions where the lower barrier layer, the compressive strain active layer and the upper barrier layer are removed, and the insulating film is formed in a region on the second cladding layer, the region corresponding to the portions where the lower barrier layer, the compressive strain active layer and the upper barrier layer are removed. As a result, injection of current to the window region can be suppressed more effectively, and an increase in optical output power can be achieved.

By forming the ridge portion obtained by removing a portion of the cladding layer of the second conductive type and by constructing the current confinement structure in the cladding layer of the second conductive type as composed of a plurality of layers, the structure provided with a refractive index waveguide mechanism can be obtained. Thus, it is made possible to perform mode control of a laser beam with a high precision.

According to the method of manufacturing a semiconductor laser device of the second aspect of the present invention, when the plurality of semiconductor layers are laminated, and when the window structure and the current injection opening are formed, a GaAs cap layer is laminated on the InGaP cap layer serving as a re-growth surface afterwards, and a predetermined spot of a layer formed under the GaAs cap layer is removed using the GaAs cap layer as a mask. Thereafter, the GaAs cap layer is removed. By use of the above-described steps, it is made possible to prevent formation of a spontaneous oxide film over the InGaP cap layer and transmutation of the layer caused by formation of the resist layer directly thereon. Furthermore, by preventing adhesion of organic matter apt to remain on the re-growth surface, occurrence of crystal defects is controlled, and element characteristics and reliability of the device can be improved.

The semiconductor laser device according to the third aspect of the present invention has the current injection control structure so as to control the current injection to the end faces with numerous surface levels, making it possible to restrain occurrence of nonluminous recombination on the surface and to suppress occurrence of COMD.

Moreover, the semiconductor laser device according to the fourth aspect of the present invention has the so-called window structure in which a region where no active layer exists in the portion in the vicinity of at least one end face of the resonator end faces and this region is buried with the layer equivalent to the upper first optical waveguide layer having a band gap larger than that of the active layer. The provision of this window structure makes it possible to control absorption of a laser beam in the vicinity of the end face and to suppress occurrence of COMD so as to obtain high reliability even at high power oscillation.

The semiconductor laser device having the above-mentioned current injection control structure and window structure concurrently can greatly suppress the current injection to the window region and further realize an increase in optical output power.

Moreover, since the first conductive type or undoped InGaP, which is lattice-matched with the GaAs substrate, is used as a lower optical waveguide layer and an upper first optical waveguide layer, a band gap difference between the active layer and the optical waveguide layer can be largely taken so as to obtain a semiconductor laser device with a good temperature characteristic that suppresses the leakage of carriers from the active layer.

Still moreover, the use of InGaP as an optical waveguide layer can obtain manufacturing advantages that control of etching depth upon forming the window structure is made easy and regrowth is made easy since a regrowth interface becomes a P (phosphorus) surface, etc.

Still further, the semiconductor laser devices according to the third and fourth aspects of the present invention are structured to have the upper second optical waveguide layer buried in the opening of the current confinement layer and the upper cladding layer formed thereon. In such a manner described above, a layer to be used as a regrowth layer is formed into a two-layered structure, so that the Al composition ratio of the $In_{0.49}(Al_{z2}Ga_{1-z2})_{0.51}P$ current confinement layer can be controlled low. The control of Al composition makes it possible to solve the problem resulting from the high Al composition.

DESCRIPTION OF THE DRAWINGS

Figs. 1A to 1C are cross-sectional views of a semiconductor laser device as the first embodiment of the present invention.

Figs. 2A to 2C are cross-sectional views of a semiconductor laser device as the second embodiment of the present invention.

Figs. 3A to 3C are cross-sectional views of a semiconductor laser device as the third embodiment of the present invention.

Figs. 4A to 4C are cross-sectional views of a semiconductor laser device as the fourth embodiment of the present invention.

Figs. 5A to 5C are cross-sectional views of a semiconductor laser device as the fifth embodiment of the present invention.

Figs. 6A to 6C are cross-sectional views of a semiconductor laser device as the sixth embodiment of the present invention.

Figs. 7A to 7C are cross-sectional views of a semiconductor laser device as the seventh embodiment of the present invention.

Figs. 8A to 8C are cross-sectional views of a semiconductor laser device as the eighth embodiment of the present invention.

Figs. 9A to 9C are cross-sectional views of a semiconductor laser device as the ninth embodiment of the present invention.

Figs. 10A to 10C are cross-sectional views of a semiconductor laser device as the tenth embodiment of the present invention.

DESCRIPTION OF PREFERRED EMBODIMENTS

Embodiments of the present invention are explained in detail below with reference to the drawings.

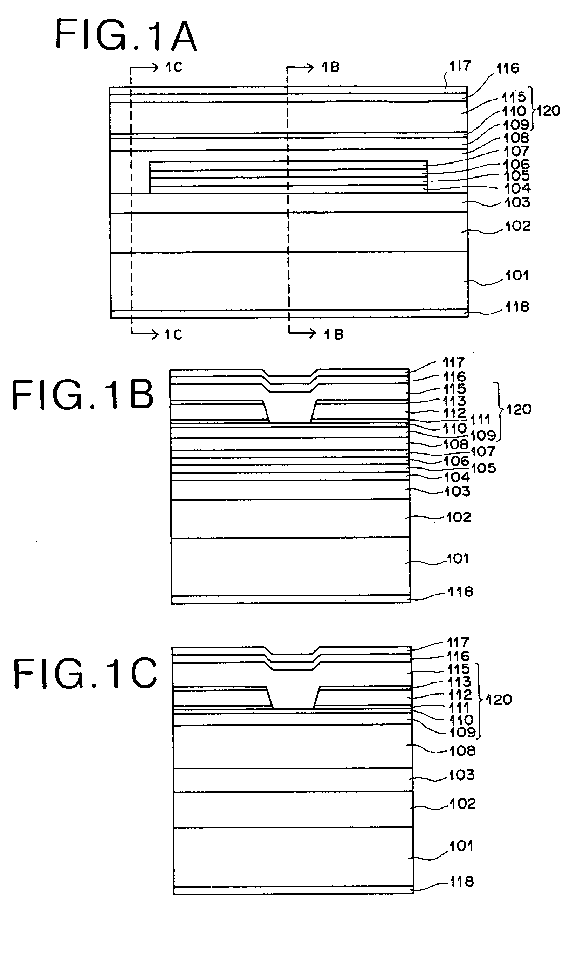

Now, embodiments of a semiconductor laser device according to the present invention will be described in detail with reference to Figs. 1A to 6C.

First Embodiment

The semiconductor laser device of a first embodiment of the present invention will be described in detail with reference to Figs. 1A to 1C. In the drawings, Fig. 1A is a sectional side view including an active region. Fig. 1B is a sectional view taken along the line 1B-1B, which shows the central portion of the semiconductor laser device in the direction perpendicular to a resonance direction thereof. Fig. 1C is a sectional view taken along the line 1C-1C, which is the sectional view in the vicinity of an end face of the semiconductor laser device in the direction perpendicular to the resonance direction thereof.

A first embodiment of the present invention is shown in Figs. 1A to 1C, and the structure of the semiconductor laser device of this embodiment will be described together with manufacturing processes for manufacturing the semiconductor laser device. First, on a n-type GaAs substrate 101, laminated are an n-type $Ga_{1-z1}Al_{z1}As$ cladding layer 102 ($0.57 \leq z1 \leq 0.8$), an n-type or i-type $In_{0.49}Ga_{0.51}P$ lower optical waveguide layer 103, an i-type $In_{x1}Ga_{1-x1}As_{1-y1}P_{y1}$ lower barrier layer 104 ($0 \leq x1 \leq 0.3$, $0 \leq y1 \leq 0.6$), an $In_{x3}Ga_{1-x3}As_{1-y3}P_{y3}$ compressive strain quantum well active layer 105 ($0.49y3 < x3 \leq 0.4$, $0 \leq y3 \leq 0.1$), an i-type $In_{x1}Ga_{1-x1}As_{1-y1}P_{y1}$ upper barrier layer 106 having a film thickness of about 5 nm, and an $In_{0.49}Ga_{0.51}P$ cap layer 107 having a film thickness of about 10 nm by an organometallic vapor phase growth method. Resist is coated on the cap layer 107. By use of an ordinary lithography technique, a removal process is performed on the resist so as to form stripe-shaped portions having a width of about 40 μm at a predetermined cycle of a resonator length, which extend in a direction expressed by the following formula.

[Formula 1] $<0\bar{1}1>$

The $In_{0.49}Ga_{0.51}P$ cap layer 107 is etched by hydrochloric acid etchant using this resist as a mask, so as to expose the $In_{x1}Ga_{1-x1}As_{1-y1}P_{y1}$ upper barrier layer 106. At this time, since the hydrochloric acid etchant is used, etching is automatically stopped immediately before the etching progresses to the upper surface of the $In_{x1}Ga_{1-x1}As_{1-y1}P_{y1}$ upper barrier layer 106. Subsequently, the resist is removed, and etching is performed by use of sulfuric acid etchant until the $In_{0.49}Ga_{0.51}P$ lower optical waveguide layer 103 is exposed. At this time, since the sulfuric acid etchant is used, the etching is automatically stopped immediately before the etching progresses to the upper surface of the $In_{0.49}Ga_{0.51}P$ lower optical waveguide layer 103. In such a manner described above, the stripe-shaped portions (the portions in the vicinity of the end face) of the active layer 105, the lower and upper barrier layers 104 and 106 and the $In_{0.49}Ga_{0.51}P$ cap layer 107, which have a width of 40 μm and include a setting position of a resonator end, are removed.

Subsequently, a p-type or i-type $In_{0.49}Ga_{0.51}P$ upper optical waveguide layer 108 is grown so as to bury the removed portions in the vicinity of the end face. Subsequently formed are a p-type $Ga_{1-z1}Al_{z1}As$ first cladding layer 109, a p-type $In_{0.49}Ga_{0.51}P$ first etching stop layer 110 having a film thickness of about 10 nm, a GaAs second etching stop layer 111 having a film thickness of about 10 nm, an n-type $In_{0.5}(Ga_{1-z2}Al_{z2})_{0.5}P$ current confinement layer 112 ($0.2 \leq z2 \leq 1$), an n-type $In_{0.49}Ga_{0.51}P$ cap layer 113 and a GaAs layer (not shown). Thereafter, resist is coated. Then, stripe-shaped regions of the resist are removed in a $<011>$ direction perpendicular to the stripe-shaped portions already removed. The stripe-shaped regions of this resist correspond to a current injection opening having a width of about 1 μm to 3 μm. Stripe-shaped portions of the GaAs cap layer exposed from the resist, which correspond to the current injection opening, are removed by sulfuric acid etchant using the resist as a mask. At this time, the etching is automatically stopped immediately before the etching progresses to the upper surface of the $In_{0.49}Ga_{0.51}P$ cap layer 113. Thereafter, the resist is removed, stripe-shaped portions of the $In_{0.49}Ga_{0.51}P$ cap layer 113 exposed on the stripe-shaped portions of the GaAs cap layer are removed by hydrochloric acid etchant using the GaAs cap layer as a mask, and hence the current injection opening is formed. Subsequently, stripe-shaped portions of the n-type $In_{0.5}(Ga_{1-z2}Al_{z2})_{0.5}P$ current confinement layer 112 are removed, thus forming the current injection opening. Thereafter, the GaAs cap layer used as the mask is removed by sulfuric acid etchant and simultaneously stripe-shaped portions of the GaAs second etching stop layer are removed, thus forming the current injection opening.

Subsequently, a p-type $Ga_{1-z1}Al_{z1}As$ second cladding layer 115 and a p-type GaAs contact layer 116 are grown, and a p electrode 117 is formed on the contact layer 116. Thereafter, the substrate 101 is polished and an n electrode is formed on the polished surface. From the p-type first cladding layer 109 to the p-type second cladding layer 115 collectively constitute a p-type cladding layer (a cladding layer of the second conductive type) 120.

Thereafter, a high reflectance coating is provided on one of resonator surfaces formed by cleaving a sample at a position where the resonator end face is set, and a low reflectance coating is provided on the other resonator surface thereof. Then, the above construction is formed into a chip, thus completing the semiconductor laser device.

The p-type cladding layer 109 shall have a film thickness with which the semiconductor laser device can realize a high output power in a fundamental transverse mode oscillation, and the p-type first and second cladding layers 109 and 115 shall have compositions with which the semiconductor laser device can realize a high output power in the fundamental transverse mode. Specifically, the film composition is set to a value so that an equivalent refractive index step difference is in a range from $1.5 \times 10^{-3}$ to $7 \times 10^{-3}$. The composition of each cladding layer may satisfactorily be one having a band gap larger than that of the optical waveguide layer. As a material of each cladding layer, InGaAlP series material or InGaAlAsP series material which is lattice-matched with the GaAs substrate 101 can be employed in addition to the foregoing GaAlAs. Furthermore, the active layer may be a multiple quantum well.

Moreover, in the manufacturing step for removing the portion in the vicinity of the end face the following steps can be also used. First, a GaAs cap layer having a film thickness of about 10 nm is formed on the $In_{0.49}Ga_{0.51}P$ cap layer 107, and resist is coated on the GaAs cap layer. By use of an ordinary lithography technique, a removal process is performed on the resist so as to form stripe-shaped portions having a width of about 40 μm at a predetermined cycle of a resonator length, which extend in a direction expressed by the following formula.

[Formula 2] $<0\bar{1}1>$

The GaAs cap layer is removed to be stripe-shaped by sulfuric acid etchant using this resist as a mask. After the resist is removed, the $In_{0.49}Ga_{0.51}P$ cap layer 107 is removed by hydrochloric acid etchant using the GaAs cap layer as a mask. Subsequently, an etching step is performed with sulfuric acid etchant until the entire GaAs cap layer is removed and simultaneously the $In_{0.49}Ga_{0.51}P$ lower optical waveguide layer 103 is exposed. By using the steps in which the GaAs cap layer is provided on the $In_{0.49}Ga_{0.51}P$ cap layer 107 in the above described manner, and then this GaAs cap layer is removed, it is possible to prevent adhesion of organic substances remaining on a re-growth surface.

Second Embodiment

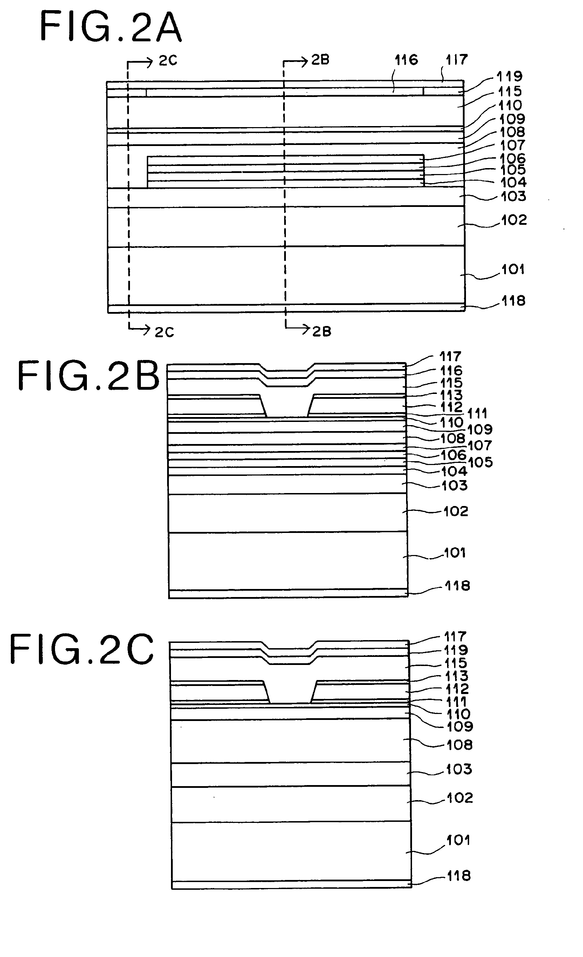

A second embodiment of the present invention is shown in Figs. 2A to 2C. In the drawings, Fig. 2A is a sectional side view including an active region. Fig. 2B is a sectional view taken along the line 2B-2B, which shows the central portion of the semiconductor laser device in the direction perpendicular to a resonance direction thereof. Fig. 2C is a sectional view taken along the line 2C-2C, which is the sectional view in the vicinity of an end face of the semiconductor laser device in the direction perpendicular to the resonance direction thereof. Only differences of a semiconductor laser device from that of the first embodiment will be described. The same layers as in the first embodiment are denoted by the same reference numerals, and detailed descriptions for them are omitted.

Steps performed until the p-type GaAs contact layer 116 is formed are identical to the manufacturing steps of the first embodiment. After the p-type GaAs contact layer 116 is formed, the p-type GaAs contact layer 116 is removed in the stripe-shaped region corresponding to a region (the portion in the vicinity of the end face) where the active layer 105 is removed. The portions where the p-type GaAs contact layer 116 is removed are covered with the insulating film 119. Specifically, the insulating film 119 is formed in the portion in the vicinity of the end face instead of the contact layer 116. Thus, injection of a current to the window region (the portion in the vicinity of the end face) can be significantly suppressed, and an increase in an optical output power can be achieved.

Third Embodiment

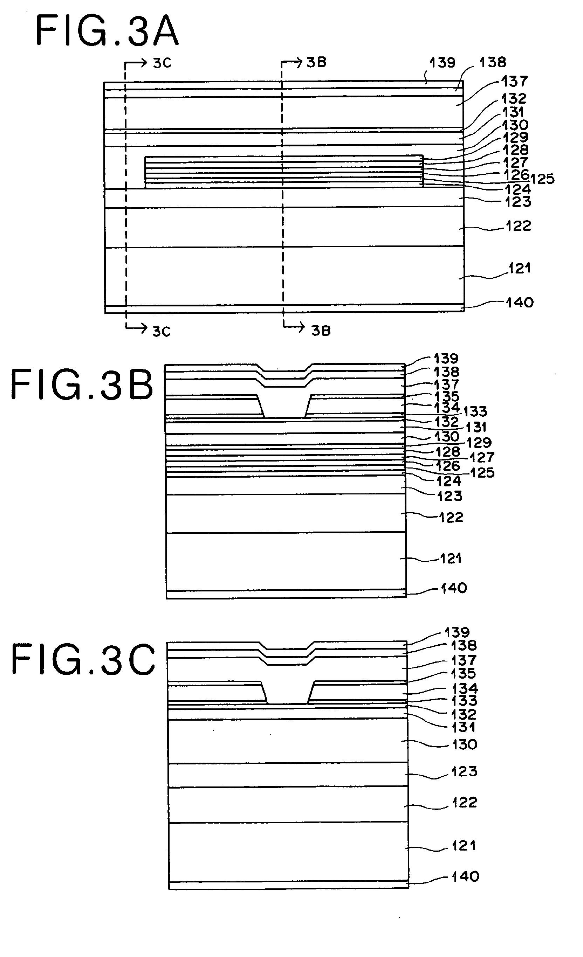

A third embodiment of the present invention is shown in Figs. 3A to 3C. In the drawings, Fig. 3A is a sectional side view including an active region. Fig. 3B is a sectional view taken along the line 3B-3B, which shows the central portion of the semiconductor laser device in the direction perpendicular to a resonance direction thereof. Fig. 3C is a sectional view taken along the line 3C-3C, which is the sectional view in the vicinity of an end face of the semiconductor laser device in the direction perpendicular to the resonance direction thereof. Descriptions of a structure of a semiconductor laser device of the third embodiment will be made together with manufacturing steps thereof. First, on a n-type GaAs substrate 121, there are laminated an n-type $Ga_{1-z1}Al_{z1}As$ cladding layer 122 ($0.57 \leq z1 \leq 0.8$), an n-type or i-type $In_{0.49}Ga_{0.51}P$ lower optical waveguide layer 123, an i-type $In_{x2}Ga_{1-x2}As_{1-y2}P_{y2}$ lower barrier layer 124 ($0 \leq x2 \leq 0.3$, $x2 = 0.49y2$) having a film thickness of about 10 nm, an i-type $In_{x4}Ga_{1-x4}As_{1-y4}P_{y4}$ lower tensile strain barrier layer 125 ($0.49y4 > x4 \geq 0$, $0 < y4 \leq 0.5$), an $In_{x3}Ga_{1-x3}As_{1-y3}P_{y3}$ compressive strain quantum well active layer 126 (0.49y3<x3≤0.4, 0≤y3≤0.1), an i-type $In_{x4}Ga_{1-x4}As_{1-y4}P_{y4}$ upper tensile strain barrier layer 127, an i-type $In_{x2}Ga_{1-x2}As_{1-y2}P_{y2}$ upper barrier layer 128 having a film thickness of about 10 nm, and an $In_{0.49}Ga_{0.51}P$ cap layer 129 having a film thickness of about 5 nm by an organometallic vapor phase growth method. Resist is coated on the $In_{0.49}Ga_{0.51}P$ cap layer 129. By use of an ordinary lithography technique, a removal process is performed on the resist so as to form stripe-shaped portions having a width of about 40 μm at a predetermined cycle of a resonator length, which extend in a direction expressed by the following formula.

[Formula 3] $<0\bar{1}1>$

The $In_{0.49}Ga_{0.51}P$ cap layer 129 is etched by hydrochloric acid etchant using this resist as a mask. Thus, the $In_{x2}Ga_{1-x2}As_{1-y2}P_{y2}$ upper barrier layer 128 is exposed. At this time, since the hydrochloric acid etchant is used, etching is automatically stopped immediately before the etching progresses to the upper surface of the $In_{x2}Ga_{1-x2}As_{1-y2}P_{y2}$ upper barrier layer 128. Subsequently, the resist is removed, and etching is performed by use of sulfuric acid etchant until the $In_{0.49}Ga_{0.51}P$ lower optical waveguide layer 123 is exposed. At this time, since the sulfuric acid etchant is used, the etching is automatically stopped immediately before the etching progresses to the upper surface of the $In_{0.49}Ga_{0.51}P$ lower optical waveguide layer 123. In such a manner described above, the stripe-shaped portions (the portions in the vicinity of the end face) of the active layer 126, the lower and upper stretch barrier layers 125 and 127, the lower and upper barrier layers 124 and 128, and the $In_{0.49}Ga_{0.51}P$ cap layer 109, which have a width of 40 μm and include a setting position of a resonator end, are removed.

Subsequently, a p-type or i-type $In_{0.49}Ga_{0.51}P$ upper optical waveguide layer 130 is grown so as to bury the removed portions in the vicinity of the end face. In addition, formed are a p-type $Ga_{1-z1}Al_{z1}As$ first cladding layer 131, a p-type $In_{0.49}Ga_{0.51}P$ first etching stop layer 132 having a film thickness of about 10 nm, a GaAs second etching stop layer 133 having a film thickness of about 10 nm, an n-type $In_{0.5}(Ga_{1-z2}Al_{z2})_{0.5}P$ current confinement layer 134 (0.2≤z2≤1) and an n-type $In_{0.49}Ga_{0.51}P$ cap layer 135. Thereafter, the resist is coated. Then, stripe-shaped regions of the resist are removed in a <011> direction perpendicular to the stripe-shaped portions already removed. The stripe-shaped regions of this resist correspond to a current injection opening having a width of about 1 μm to 3 μm. The stripe-shaped portions of the n-type $In_{0.49}Ga_{0.51}P$ cap layer 135 and the n-type $In_{0.5}(Ga_{1-z2}Al_{z2})_{0.5}P$ current confinement layer 134 are removed using this resist as a mask. At this time, the etching is automatically stopped immediately before the etching progresses to the upper surface of the GaAs second etching stop layer 133. Thereafter, the resist is removed, and stripe-shaped portions of the GaAs second etching stop layer 133 are removed by sulfuric acid etchant. Thus, a current injection opening is formed. Subsequently, a p-type $Ga_{1-z1}Al_{z1}As$ second cladding layer 137 and a p-type GaAs contact layer 138 are grown. The p electrode 139 is formed on the contact layer 138. Thereafter, the substrate 121 is polished, and an n electrode 140 is formed on the polished surface.

Thereafter, a high reflectance coating is provided on one of resonator surfaces formed by cleaving a sample at a position where the resonator end face is set, and a low reflectance coating is provided on the other resonator surface thereof. Then, the above construction is formed into a chip, thus completing the semiconductor laser device.

The p-type first cladding layer 131 shall have a film thickness and the p-type second cladding layer 137 shall have a composition, whereby the semiconductor laser device can realize a high output power in a fundamental transverse mode oscillation. Specifically, the film thickness and the composition are set so that an equivalent refractive index step difference is in a range from $1.5\ 5 \times 10^{-3}$ to $7 \times 10^{-3}$. The composition of each cladding layer may satisfactorily be one having a band gap larger than that of the optical waveguide layer. As a material of each cladding layer, InGaAlP series material or InGaAlAsP series material which is lattice-matched with the GaAs substrate 101 can be employed in addition to the foregoing GaAlAs. Furthermore, though the active layer may be a multiple quantum well, an absolute value of a sum of products of a strain quantity and a film thickness of the tensile strain barrier layer and the compressive strain active layer should be set to 0.3 nm or less.

## Fourth Embodiment

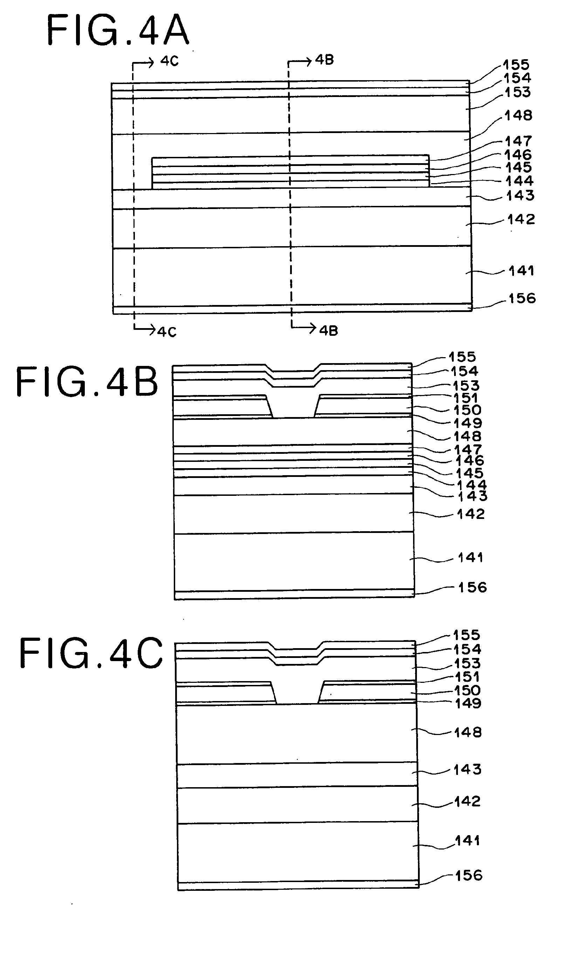

An fourth embodiment of the present invention is shown in Figs. 4A to 4C, and a structure of a semiconductor laser device of this embodiment will be described together with manufacturing steps thereof. In the drawings, Fig. 4A is a sectional side view including an active region. Fig. 4B is a sectional view taken along the line 4B-4B, which shows the central portion of the semiconductor laser device in the direction perpendicular to a resonance direction thereof. Fig. 4C is a sectional view taken along the line 4C-4C, which is the sectional view in the vicinity of an end face of the semiconductor laser device in the direction perpendicular to the resonance direction thereof. First, on an n-type GaAs substrate 141, laminated are an n-type $Ga_{1-z1}Al_{z1}As$ cladding layer 142 (0.57≤z1≤0.8), an n-type or i-type $In_{0.49}Ga_{0.51}P$ lower optical waveguide layer 143, an i-type $In_{x1}Ga_{1-x1}As_{1-y1}P_{y1}$ lower barrier layer 144 (0≤x1≤0.3, 0.1≤y1≤0.6), an $In_{x3}Ga_{1-x3}As_{1-y3}P_{y3}$ compressive strain quantum well active layer 145 (0.49y3≤x3≤0.4, 0≤y3≤0.1), an i-type $In_{x1}Ga_{1-x1}As_{1-y1}P_{y1}$ upper barrier layer 146 having a film thickness of about 5 nm, and an $In_{0.49}Ga_{0.51}P$ cap layer 147 having a film thickness of about 10 nm by an organometallic vapor phase growth method. Resist is coated on the cap layer 147. By use of an ordinary lithography technique, a removal process is performed on the resist so as to form stripe-shaped portions having a width of about 40 $\mu$m at a predetermined cycle of a resonator length, which extend in a direction expressed by the following formula.

[Formula 4] $<0\bar{1}1>$

The $In_{0.49}Ga_{0.51}P$ cap layer 147 is etched by hydrochloric acid etchant using this resist as a mask, so as to expose the $In_{x1}Ga_{1-x1}As_{1-y1}P_{y1}$ upper barrier layer 146. At this time, since the hydrochloric acid etchant is used, the etching is automatically stopped immediately before the etching progresses to the upper surface of the $In_{x1}Ga_{1-x1}As_{1-y1}P_{y1}$ upper barrier layer 146. Subsequently, the resist is removed, and etching is performed by use of sulfuric acid etchant until the $In_{0.49}Ga_{0.51}P$ lower optical waveguide layer 143 is exposed. At this time, since the sulfuric acid etchant is used, the etching is automatically stopped immediately before the etching progresses to the upper surface of the $In_{0.49}Ga_{0.51}P$ lower optical waveguide layer 143. In such a manner described above, the stripe-shaped portions (the portions in the vicinity of the end face) of the active layer 145, the lower and upper barrier layers 144 and 146 and the $In_{0.49}Ga_{0.51}P$ cap layer 147, which have a width of 40 $\mu$m and include a setting position of a resonator end, are removed.

Subsequently, a p-type or i-type $In_{0.49}Ga_{0.51}P$ upper optical waveguide layer 148, a GaAs etching stop layer 149 having a film thickness of about 10 nm, an n-type $In_{0.5}(Ga_{1-z2}Al_{z2})_{0.5}P$ current confinement layer 150 $(0.2\leq z2\leq 1)$, an n-type $In_{0.49}Ga_{0.51}P$ cap layer 151 and a GaAs cap layer are formed so as to bury the removed portions in the vicinity of the end face. Thereafter, the resist is coated, and the regions of the resist having a width of 1 $\mu$m to 3 $\mu$m in a $<011>$ direction perpendicular to the already removed stripe-shapes portions are removed, and stripe-shaped portions of the GaAs cap layer 152 are removed by sulfuric acid etchant using this resist as a mask, thus forming a current injection opening. At this time, the etching is automatically stopped immediately before the etching progresses to the upper surface of the $In_{0.49}Ga_{0.51}P$ cap layer 151. Thereafter, the resist is removed, and the stripe-shaped portions of the $In_{0.49}Ga_{0.51}P$ cap layer 151 and the n-type $In_{0.5}(Ga_{1-z2}Al_{z2})_{0.5}P$ current confinement layer 150 are removed by hydrochloric acid etchant. Thus, a current injection opening is formed. The GaAs cap layer used as the mask is removed, and the stripe-shaped portions of the GaAs etching stop layer 149 are removed, thus forming a current injection opening.

Subsequently, a p-type $Ga_{1-z1}Al_{z1}As$ second cladding layer 153 and a p-type GaAs contact layer 154 are grown. A p electrode 155 is formed on the contact layer 154. Thereafter, the substrate 141 is polished, and an n electrode 156 is formed on the polished surface.

Thereafter, a high reflectance coating is provided on one of resonator surfaces formed by cleaving a sample at a position where the resonator end face is set, and a low reflectance coating is provided on the other resonator surface thereof. Then, the above construction is formed into a chip, thus completing the semiconductor laser device.

Note that the upper optical waveguide layer 148 shall have a value and the p-type second cladding layer 153 shall have a composition, whereby the semiconductor laser device can realize a high output power in a fundamental transverse mode oscillation. Specifically, the film thickness and the composition are set so that an equivalent refractive index step difference is in a range from $1.5 \times 10^{-3}$ to $7 \times 10^{-3}$.

Fifth Embodiment

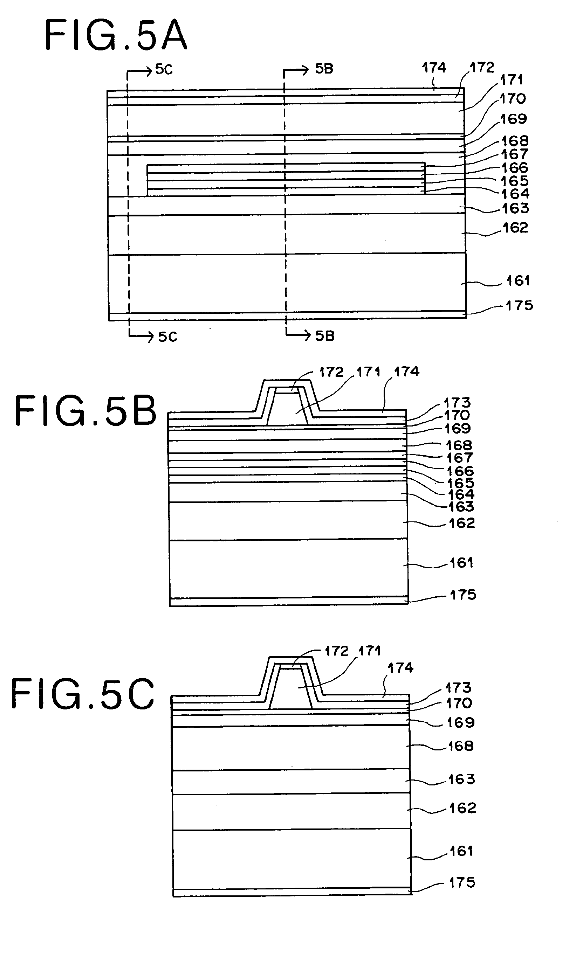

A fifth embodiment of the present invention is shown in Figs. 5A to 5C, and a structure of a semiconductor laser device of this embodiment will be described together with manufacturing steps thereof. In the drawings, Fig. 5A is a sectional side view including an active region. Fig. 5B is a sectional view taken along the line 5B-5B, which shows the central portion of the semiconductor laser device in the direction perpendicular to a resonance direction thereof. Fig. 5C is a sectional view taken along the line 5C-5C, which is the sectional view in the vicinity of an end face of the semiconductor laser device in the direction perpendicular to the resonance direction thereof. First, on an n-type GaAs substrate 161, laminated are an n-type $Ga_{1-z1}Al_{z1}As$ cladding layer 162 $(0.57\leq z1\leq 0.8)$, an n-type or i-type $In_{0.49}Ga_{0.51}P$ lower optical waveguide layer 163 having a film thickness of about 5 nm, an i-type $In_{x1}Ga_{1-x1}As_{1-y1}P_{y1}$ lower barrier layer 164 $(0\leq x1\leq 0.3, 0\leq y1\leq 0.6)$ having a film thickness of about 10 nm, an $In_{x3}Ga_{1-x3}As_{1-y3}P_{y3}$ compressive strain quantum well active layer 165 $(0.49y3<x3\leq 0.4, 0\leq y3\leq 0.1)$, an i-type $In_{x1}Ga_{1-x1}As_{1-y1}P_{y1}$ upper barrier layer 166 having a film thickness of about 10 nm and an $In_{0.49}Ga_{0.51}AsP$ cap layer 167 having a film thickness of about 5 nm by an organometallic vapor phase growth method. Resist is coated on the cap layer 167. By use of an ordinary lithography technique, a removal process is performed on the resist so as to form stripe-shaped portions having a width of about 40 $\mu$m at a predetermined cycle of a resonator length, which extend in a direction expressed by the following formula.

[Formula 5] $<0\bar{1}1>$

The $In_{0.49}Ga_{0.51}P$ cap layer 167 is etched by hydrochloric acid etchant using this resist as a mask, so as to expose the $In_{x1}Ga_{1-x1}As_{1-y1}P_{y1}$ upper barrier layer 166. At this time, since the hydrochloric acid etchant is used, the etching is automatically stopped immediately before the etching progresses to the upper surface of the $In_{x1}Ga_{1-x1}As_{1-y1}P_{y1}$ upper barrier layer 166. Subsequently, the resist is removed, and etching is performed by use of sulfuric acid etchant until the $In_{0.49}Ga_{0.51}P$ lower optical waveguide layer 163 is exposed. At this time, since the sulfuric acid etchant is used, the etching is automatically stopped immediately before the etching progresses to the upper surface of the $In_{0.49}Ga_{0.51}P$ lower optical waveguide layer 163. In such a manner described above, the stripe-shaped portions (the portions in the vicinity of the end face) of the active layer 165, the lower and upper barrier layers 164 and 166 and the $In_{0.49}Ga_{0.51}P$ cap layer 167, which have a width of 40 μm and include a setting position of a resonator end, are removed.

Subsequently, a p-type or i-type $In_{0.49}Ga_{0.51}P$ upper optical waveguide layer 168, a p-type $Ga_{1-z1}Al_{z1}As$ first cladding layer 169, a p-type $In_{0.49}Ga_{0.51}P$ etching stop layer 170 having a film thickness of about 10 nm, a p-type $Ga_{1-z1}Al_{z1}As$ second cladding layer 171 and a p-type GaAs contact layer 172 are grown so as to bury the removed portions in the vicinity of the end face. Furthermore, an insulating film (not shown) is formed, and the insulating film is removed so that stripe-shaped portions having a width of about 1 μm to 3 μm are left in a <011> direction. Both sides of the stripe-shaped portions of the p-type GaAs contact layer 172 and the p-type $Ga_{1-z1}Al_{z1}As$ second cladding layer 171 are removed by sulfuric acid etchant using this insulating film as a mask, thus forming a ridge. Subsequently, an insulating film 173 is formed, and a current injection opening is formed only in an upper portion of the ridge by an ordinary lithography technique. A p electrode 174 is formed so as to cover the current injection opening. Thereafter, the substrate 161 is polished, and an n electrode 175 is formed on the polished surface.

Thereafter, a high reflectance coating is provided on one of resonator surfaces formed by cleaving a sample at a position where the resonator end face is set, and a low reflectance coating is provided on the other resonator surface thereof. Then, the above construction is formed into a chip, thus completing the semiconductor laser device.

Note that the p-type second cladding layer shall have a film thickness with which the semiconductor laser device can realize a high output power in a fundamental transverse mode oscillation. Specifically, the film thickness is set so that an equivalent refractive index step difference is in a range from $1.5 \times 10^{-3}$ to $7 \times 10^{-3}$.

Sixth Embodiment

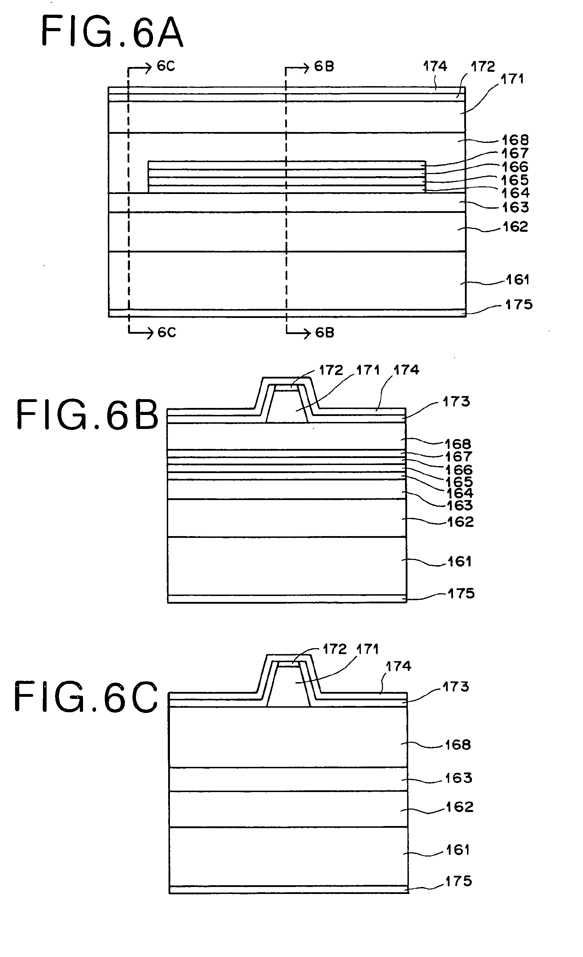

A sixth embodiment of the present invention is shown in Figs. 6A to 6C. In the drawings, Fig. 6A is a sectional side view including an active region. Fig. 6B is a sectional view taken along the line 6B-6B, which shows the central portion of the semiconductor laser device in the direction perpendicular to a resonance direction thereof. Fig. 6C is a sectional view taken along the line 6C-6C, which is the sectional view in the vicinity of an end face of the semiconductor laser device in the direction perpendicular to the resonance direction thereof. Only differences of a semiconductor laser device from that of the fifth embodiment will be described. The same layers as those in the fifth embodiment are denoted by the same reference numerals, and detailed descriptions for them are omitted.

A semiconductor laser device of the sixth embodiment of the present invention does not comprise the p-type $Ga_{1-z1}Al_{z1}As$ first cladding layer 169, the p-type $In_{0.49}Ga_{0.51}P$ etching stop layer 170 formed on the upper optical waveguide layer 168 in the fifth embodiment. As described above, the p-type cladding layer part may comprise only one p-type cladding layer.

Note that the upper optical waveguide layer 168 shall have a film thickness with which the semiconductor laser device can realize a high output power in a fundamental transverse mode. Specifically, the film thickness is set so that an equivalent refractive index step difference is in a range from $1.5 \times 10^{-3}$ to $7 \times 10^{-3}$.

In the semiconductor laser devices from the first to sixth embodiments, the composition of the $In_{x3}Ga_{1-x3}As_{y3}P_{1-y3}$ compressive strain active layer is controlled in a range of $0.49y3 \leq x3 \leq 0.4$ and $0 \leq y3 \leq 0.1$, whereby an oscillation wavelength can be controlled in a range of $900 < \lambda < 1200$ (nm).

As a growth method of each semiconductor layer, a molecular beam epitaxial growth method using a solid or a gaseous raw material may be employed.

Particularly, the suffixes x, y and z that are not particularly range-specified have values ranging from 0 to 1, and they are properly decided depending on lattice match conditions, lattice unmatched conditions, a scale of a band gap and a magnitude of a refractive index regarding an oscillation wavelength.

In the above-described embodiments, though the n-type GaAs substrate was used, a p-type GaAs substrate may be also employed. In this case, layers having opposite conductivity type to those of the layers used in the semiconductor laser devices in the above described embodiments may be laminated.

A semiconductor laser element according to each of the above-described embodiments can generate a laser beam with a high level optical output while maintaining a fundamental transverse mode. The present invention is effective not only in laser elements that oscillate a fundamental transverse mode, but in semiconductor laser elements that oscillate in a multi-mode having an oscillation region width of 3 μm or wider, and thus a highly reliable semiconductor laser element of a multi-mode oscillation with low-noise and high-output oscillation can be obtained.

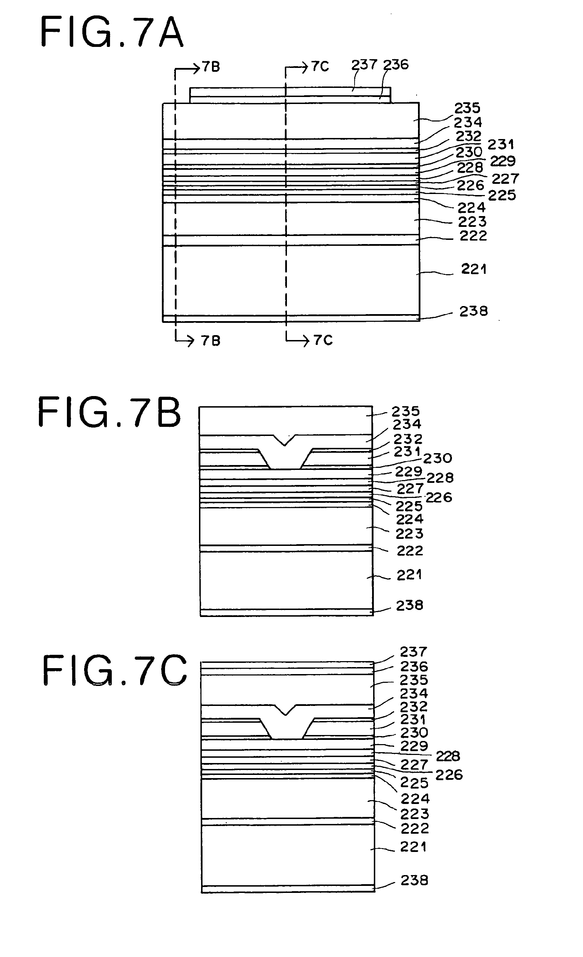

Embodiments of the present invention are explained in detail using Figs. 7 to 10. In each figure, (A) is a sectional side view cut at a surface including an active region, (B) is a cross-sectional view taken along the line B-B(the cross-sectional view in the vicinity of an end face of the semiconductor laser device in the direction perpendicular to the resonance direction thereof), and (C) is a cross-sectional view taken along the line C-C (the central portion of the semiconductor laser device in the direction perpendicular to a resonance direction thereof).

The seventh embodiment of the present invention is shown in Fig. 7. The present semiconductor laser device comprises an n-type GaAs buffer layer 222, an n-type $Al_{z1}Ga_{1-z1}As$ lower cladding layer 223 ($0.57 \leq z1 \leq 0.8$), an n-or i-type $In_{0.49}Ga_{0.51}P$ lower optical waveguide layer 224, an i-type $In_{x3}Ga_{1-x3}As_{1-y3}P_{y3}$ lower barrier layer 225 ($0 \leq x3 \leq 0.3, 0.1 \leq y3 \leq 0.6$), a compressive strain $In_{x1}Ga_{1-x1}As_{1-y1}P_{y1}$ quantum well active layer 226 ($0 < x1 \leq 0.4, 0 \leq y1 \leq 0.1$), an i-type $In_{x3}Ga_{1-x3}As_{1-y3}P_{y3}$ upper barrier layer 227 ($0 \leq x3 \leq 0.3, 0.1 \leq y3 \leq 0.6$), an $In_{0.49}Ga_{0.51}P$ first cap layer 228, a p-or i-type $In_{0.49}Ga_{0.51}P$ upper first optical waveguide layer 229, a p-type GaAs etching stop layer 230 having an opening serving as a current passage (thickness of about 10 nm), an n-type $In_{0.49}(Al_{z2}Ga_{1-z2})_{0.51}P$ current confinement layer 231 with an opening serving as a current passage, an n-type $In_{0.49}Ga_{0.51}P$ second cap layer 232 with an opening serving as a current passage (thickness of about 10 nm), a p-type $In_{0.49}Ga_{0.51}P$ upper second optical waveguide layer 234 formed to bury the opening, a p-type $Al_{z1}Ga_{1-z1}As$ upper cladding layer 235 ($0.57 \leq z1 \leq 0.8$), and a p-type GaAs contact layer 236, those which are formed on an n-type GaAs substrate 221 sequentially, and further a p-side electrode 237 on the contact layer 236, and an n-side electrode 238 on a face opposite with the semiconductor laminated surface of the substrate 221.

In the present semiconductor laser device, the contact layer 236 and the p-side electrode 237 formed on the upper surface of the contact layer 236 are not formed in a region which is up to about 20 μm inwardly from an end face of a resonator (a portion in the vicinity of the end face). In this way, the contact layer 236 and the electrode 237 are structured not to be formed on the portion in the vicinity of the end face, so that the current injection to the portion in the vicinity of the end face is suppressed, making it possible to restrain occurrence of nonluminous recombination and to suppress occurrence of COMD on the end face. Note that the electrode 237 may not always have the same size as that of the contact layer 236, and may be extended toward the end face from the contact layer 236.

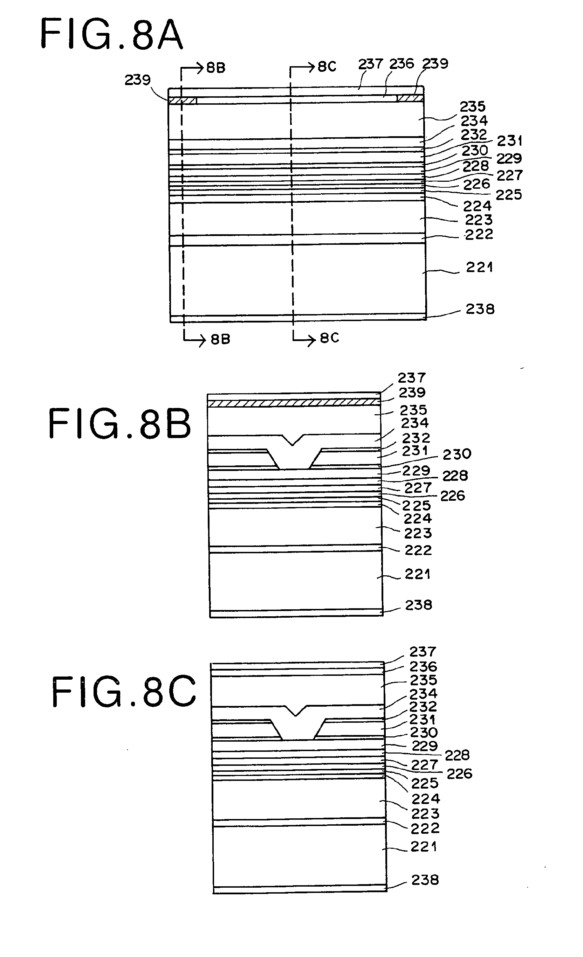

The eighth embodiment of the present invention is shown in Fig. 8. The present semiconductor laser device has substantially the same layer structure as that of the seventh embodiment, but it is different from the seventh embodiment in the point that an insulation film 239 is formed on the portion which is on the upper surface of the upper cladding layer 235 and which is the portion in the vicinity of the end face where no contact layer 236 is formed and the point that the p-side electrode 237 is formed on the contact layer 236 and insulation film 239. Similar to the above-mentioned case, this case can obtain an effect that controls the current injection to the portion in the vicinity of the end face so as to suppress occurrence of nonluminous recombination on the end face.

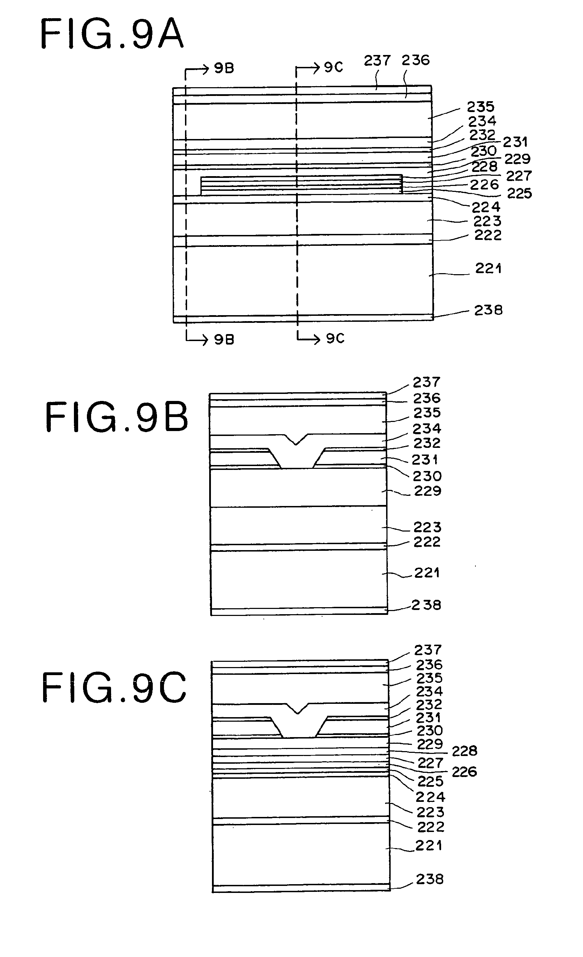

The ninth embodiment of the present invention is shown in Fig. 9. The present semiconductor laser device has substantially the same layer structure as that of the seventh embodiment, but it is different from the seventh embodiment in the point that the layers including the lower barrier layer 225 to the first cap layer 228 are formed only inwardly from the position away from the end faces of the resonator by a predetermined distance and the upper first optical waveguide layer is buried in the portion in the vicinity of the end face, which is from the edge portions of these layers to the end face of the resonator and the point that the contact layer 236 is formed on the entire surface of the upper cladding layer 235, and the p-side electrode 237 of the contact layer 236 is also formed on the entire surface of the laminated surface.

Even if the contact layer 236 and the p-side electrode 237 are structured to be formed on the entire surface of the laminated surface, by providing the so-called window structure in which the portions of the lower barrier layer 225 to the first cap layer 228 in the vicinity of the end faces are removed and an optical waveguide layer with a band gap larger than that of the active layer is buried in the removed portions, it is possible to control absorption of a laser beam in the vicinity of the end portion and to suppress occurrence of COMD.

An explanation will be next given of the specific manufacturing method for the semiconductor laser device according to the ninth embodiment. First, an n-type GaAs buffer layer 222, an n-type $Al_{z1}Ga_{1-z1}As$ lower cladding layer 223 ($0.57 \leq z1 \leq 0.8$), an n-or i-type $In_{0.49}Ga_{0.51}P$ lower optical waveguide layer 224, an i-type $In_{x3}Ga_{1-x3}As_{1-y3}P_{y3}$ lower barrier layer 225 ($0 \leq x3 \leq 0.3, 0.1 \leq y3 \leq 0.6$), a compressive strain $In_{x1}Ga_{1-x1}As_{1-y1}P_{y1}$ quantum well active layer 226 ($0 < x1 \leq 0.4, 0 \leq y1 \leq 0.1$), an i-type $In_{x3}Ga_{1-x3}As_{1-y3}P_{y3}$ upper barrier layer 227 ($0 \leq x3 \leq 0.3, 0.1 < y3 \leq 0.6$), and an $In_{0.49}Ga_{0.51}P$ first cap layer 228 are laminated on an n-type GaAs substrate 221 in this order by an organometallic vapor phase growth method. The first cap layer 228 is coated with resist. With general photolithography, the resist on the strip-shaped portions having a width of about 40 μm at an interval of a predetermined resonator length, which extend in a direction expressed by the following formula.

[Formula 6] <0$\bar{1}$1>

The $In_{0.49}Ga_{0.51}P$ first cap layer 228 is etched by hydrochloric acid etchant using this resist as a mask, so as to expose the i-type $In_{x3}Ga_{1-x3}As_{1-y3}P_{y3}$ upper barrier layer 227. At this time, since the hydrochloric acid etchant is used, etching is automatically stopped at the upper surface of the i-type $In_{x3}Ga_{1-x3}As_{1-y3}P_{y3}$ upper barrier layer 227. Subsequently, the resist is removed, and etching is performed by use of sulfuric acid etchant until the $In_{0.49}Ga_{0.51}P$ lower optical waveguide layer 224 is exposed. The etching is automatically stopped at the upper surface of the $In_{0.49}Ga_{0.51}P$ lower optical waveguide layer 224. In such a manner described above, the stripe-shaped portions (the portions in the vicinity of the end face) of the active layer 226, the lower and upper barrier layers 225 and 227 and the first cap layer 228, which have a width of 40 µm and which include a setting position of a resonator end face, are removed.

Subsequently, a p- or i-type $In_{0.49}Ga_{0.51}P$ upper first optical waveguide layer 229 is grown so as to bury the removed portions in the vicinity of the end face. Subsequently, there are formed a p-type GaAs etching stop layer 230 (thickness of about 10 nm), an n-type $In_{0.49}(Al_{z2}Ga_{1-z2})_{0.51}P$ current confinement layer 231, an n-type $In_{0.49}Ga_{0.51}P$ second cap layer 232 (thickness of about 10 nm) and an n-type GaAs third cap layer (thickness of about 10 nm) (not shown). Thereafter, the third cap layer is coated with resist. Then, the resist on stripe-shaped regions, which correspond to a current injection opening having a width of about 1 µm to 3 µm, is removed in a <011> direction perpendicular to the stripe-shaped portions already removed. Stripe-shaped portions of the n-type GaAs third cap layer exposed to the opening of the resist, which correspond to the current injection opening, are removed by sulfuric acid etchant using the resist as a mask. At this time, the etching is automatically stopped at the upper surface of the n-type $In_{0.49}Ga_{0.51}P$ second cap layer 232. Thereafter, the resist is removed, stripe-shaped portions of the n-type $In_{0.49}Ga_{0.51}P$ second cap layer 232 exposed to the opening of the third cap layer are removed by hydrochloric acid etchant using the n-type GaAs third cap layer as a mask, and sequentially the strip-shaped portions of the n-type $In_{0.49}(Al_{z2}Ga_{1-z2})_{0.51}P$ current confinement layer 231 are removed so as to form a current injection opening. At this time, the etching is automatically stopped at the n-type GaAs etching stop layer 230. Moreover, the n-type GaAs etching stop layer 230 exposed to the opening portion is removed by sulfuric acid etchant and the residual n-type GaAs third cap layer is removed.

Subsequently, a p-type $In_{0.49}Ga_{0.51}P$ upper second optical waveguide layer 234, a p-type $Al_{z1}Ga_{1-z1}As$ upper cladding layer 235 ($0.57 \leq z1 \leq 0.8$) and a p-type GaAs contact layer 236 are formed. Thereafter, a p-side electrode 237 is formed on the contact layer 236, the substrate 221 is polished, and an n-side electrode 238 is formed on the polished surface.

Thereafter, a high reflectance coating is provided on one of resonator surfaces formed by cleaving a sample at a position where the resonator end face is set, and a low reflectance coating is provided on the other resonator surface thereof. Then, the above construction is formed into a chip, thus completing the semiconductor laser device.

Here the thickness of the p-type $In_{0.49}Ga_{0.51}P$ upper second optical waveguide layer 234 and the composition and thickness of the n-type $In_{0.49}(Al_{z2}Ga_{1-z2})_{0.51}P$ current confinement layer 231 are set in a condition that a fundamental transverse mode oscillation can be maintained up to high power, specifically, an equivalent refractive index step difference between the stripe shaped regions and the current confinement layer region is in a range from $1.5 \times 10^{-3}$ to $7.0 \times 10^{-3}$.

Additionally, in order to compensate for the stress of the compressive strained active layer, an $In_{x2}Ga_{1-x2}As_{1-y2}P_{y2}$ strain compensation layer ($0 \leq x2 < 0.49y2$, $0 < y2 \leq 0.5$), which has a band gap larger than that of the active layer and which has tensile strain stress, may be formed between the active layer and the barrier layer. In this case, the sum of the product of the strain quantity and the thickness of the compressive strain active layer and the product of the strain quantity and the thickness of the tensile strain compensation layer is set to be within 0.3 nm.

Regarding the conductivities of the GaAs etching stop layer 230, $In_{0.49}Ga_{0.51}P$ second cap layer 232 and GaAs third cap layer, either of n-type or p-type may be used.

Note that, though this embodiment uses $In_{0.49}Ga_{0.51}P$ as upper second optical waveguide layer 234, the same effect can be obtained if $Al_{z3}Ga_{1-z3}As$ ($0.50 \leq z3 \leq 0.54$) having substantially the same refractive index as that of $In_{0.49}Ga_{0.51}P$ is used.

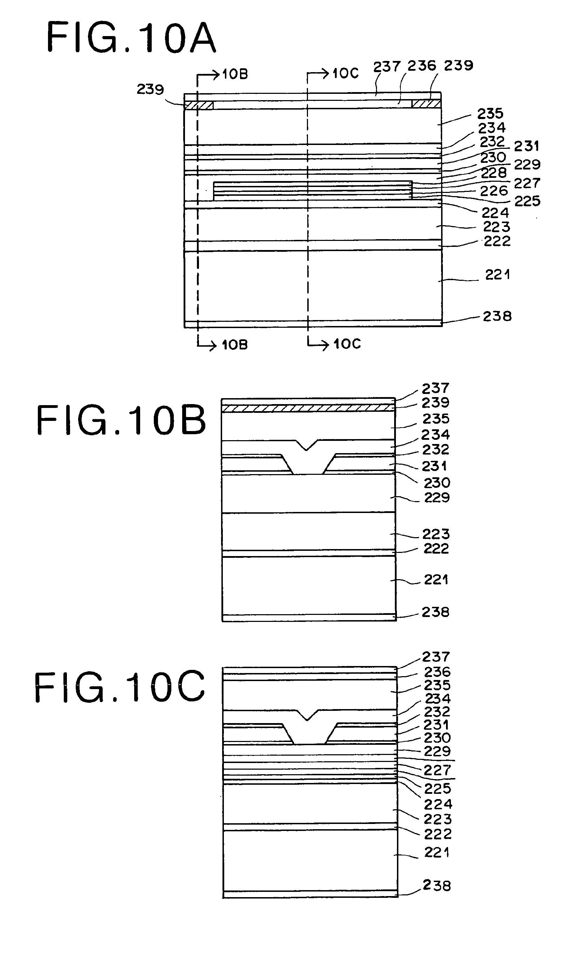

The tenth embodiment of the present invention is shown in Fig. 10. As illustrated in Fig. 10, the semiconductor laser device of this embodiment is one that has the structure in which the end face current injection control structure of the eighth embodiment and the window structure of the ninth embodiment are combined and that has higher reliability in which a current injection to a window region is greatly suppressed so as to increase a window effect.

An explanation will be given of the manufacturing method of the present semiconductor laser device. After forming the layers up to the p-type GaAs contact layer 236 by the same method as that of the manufacturing method of the ninth embodiment, the p-type GaAs contact layer 236 of the stripe-shaped region in the vicinity of the end face, which corresponds to the region where the active layer is removed, is eliminated. The removed portion is covered with an insulation film 239. Thereafter, a p-side electrode 237 is formed thereon, and the substrate 221 is polished so as to form an n-side electrode 238 on the polished surface. Thereafter, a high reflectance coating and a low reflectance coating are provided on the resonator surfaces formed by cleaving a sample, and then the above construction is formed into a chip, thus completing the semiconductor laser device.

Here, as a combination of the end face current injection control structure and the window structure, the structure having the end face current injection control structure of the seventh embodiment may be used. For forming such a device, there may be used a method in which the p-type GaAs contact layer 236 of the stripe region corresponding to the region where the active layer is removed is eliminated, thereafter the p-side electrode 237 is formed thereon along the p-type GaAs contact layer 236.

In addition, as shown in Fig. 10, the end face current injection control structure may be provided onto both low reflectance coating side and high reflectance coating side or only one of the low reflectance coating side and high reflectance coating side. Moreover, even if the window structure is formed on only one end face, a constant effect that suppresses COMD can be obtained.

In semiconductor laser devices from the seventh to tenth embodiments described above, $In_{0.49}(Ga_{1-z4}Al_{z4})_{0.51}P$ layers ($0.1 \leq z4 \leq z2$) may be used as lower and upper cladding layers.

Moreover, in the fabrication of each semiconductor laser device, molecular beam epitaxy using solid or gas raw material may be used as growth of each semiconductor layer.

In the above-mentioned embodiments, the GaAs substrate with n-type conductivity was described. However, a GaAs substrate with p-type conductivity may be also employed. In this case, all conductivities of layers may be changed to be opposite to those of the layers used in the semiconductor laser devices in the above-described embodiments.

Still moreover, the composition ratio of the $In_{x1}Ga_{1-x1}As_{1-y1}P_{y1}$ active layer is controlled in a range of $0 < x1 \leq 0.4$, $0 \leq y1 \leq 0.1$, making it possible to complete a semiconductor laser device having a peak oscillation wavelength in a range of $900 < \lambda < 1200$ (nm).

Furthermore, the quantum well in the active layer was a single layer in the aforementioned embodiments. However, there may be used a structure having a multiple quantum well in which quantum wells are laminated in a multilayer manner. In the case of the multiple quantum well structure, there may be used a structure in which a layer, which is made of the same material as that of the optical waveguide layer or the barrier layer, is interposed between the respective quantum well layers.

Additionally, the above explained the manufacturing method of the semiconductor laser device that provided a fundamental transverse mode oscillation. However, there may be used a refractive index waveguide type semiconductor laser device, which has a stripe width of 4 μm or more and which provides a multimode oscillation. Regarding the semiconductor laser device having a strite width of 4 μm or more, its

equivalent refractive index step difference ΔN is set to $2 \times 10^{-3}$ or more. The above-structured semiconductor laser device with the wide stripe has a low noise characteristic and can be used as a semiconductor laser device with high power required for solid laser excitation and the like.

Note that the semiconductor laser device structure of the present invention can be used in fabricating not only the semiconductor laser devices with a refractive index waveguide mechanism but also the semiconductor laser devices having a diffraction lattice, or optical integrated circuits.

**Claims**

1.  A semiconductor laser device comprising:

    a GaAs substrate of a first conductivity type; and
    a semiconductor layer formed on said GaAs substrate, said semiconductor layer including:

    a cladding layer of the first conductive type, formed on said GaAs substrate;
    a lower optical waveguide layer made of InGaP of an undoped type or the first conductive type, said lower optical waveguide layer being formed on said lower cladding layer;
    a compressive strain active layer made of any one of InGaAsP and InGaAs, said compressive strain active layer being formed on said lower optical waveguide layer;
    an upper optical waveguide layer made of InGaP of an undoped type or a second conductive type, said upper optical waveguide layer being formed on said compressive strain active layer; and
    a cladding layer part of the second conductive type,
    wherein a lower barrier layer made of InGaAsP having a band gap larger than that of said compressive strain active layer is provided between said lower optical waveguide layer and said compressive strain active layer,
    an upper barrier layer made of InGaAsP having a band gap lager than that of said compressive strain active layer is provided between said compressive strain active layer and said upper waveguide layer,
    portions of said lower barrier layer, said compressive strain active layer and said upper barrier layer are removed, said portions being adjacent to two opposite end faces among end faces obtained by cleaving said semiconductor layer, said two opposite end faces constituting a resonator end face,

said lower and upper optical waveguide layers have band gaps larger than that of said compressive strain active layer, and said upper optical waveguide layer is buried in the removed portions of said lower barrier layer, said compressive strain active layer and said upper barrier layer.

2. A semiconductor laser device according to claims 1 or 3, wherein said compressive strain active layer is made of $In_{x3}Ga_{1-x3}As_{1-y3}P_{y3}$, where $0.49y3<x3\leq0.4$ and $0\leq y3\leq0.1$.

3. A semiconductor laser device according to claims 1 or 3, wherein a contact layer of the second conductive type is formed in a region on said second conductive type cladding layer part, the region excluding a region corresponding to the portions where said lower barrier layer, said compressive strain active layer and said upper barrier layer are removed, and

an insulating film is formed in a region on said second conductive type cladding layer part, the region corresponding to said portions where said lower barrier layer, said compressive strain active layer and said upper barrier layer are removed.

4. A semiconductor laser device according to claims 1 or 3, wherein a ridge portion is provided, which is formed by removing both sides of a stripe-shaped portion of said cladding layer part of the second conductive type extending from one resonator end face to the other resonator end face, from an upper surface of said cladding layer part of the second conductive type to a predetermined position,

5. A semiconductor laser device according to claim 1, wherein said cladding layer part of the second conductive type comprises:

a first cladding layer of the second conductive type, being formed on said upper optical waveguide layer;
a first etching stop layer of the second conductive type made of InGaP, being formed on said first cladding layer;
a second etching stop layer made of GaAs having a stripe-shaped current injection opening extending from one resonator end face to the other resonator end face, said second etching stop layer being formed on said first etching stop layer;
a current confinement layer of the first conductive type made of InGaAlP having a stripe-shaped current injection opening extending from one resonator end face to the other resonator end face, said current confinement layer being formed on said second etching stop layer;
a cap layer of the first conductive type made of InGaP having a stripe-shaped current injection opening extending from one resonator end face to the other resonator end face, said cap layer being formed on said current confinement layer; and
a second cladding layer of the second conductive type, being formed on said cap layer.

6. A semiconductor laser device according to claim 1, wherein said cladding layer part of the second conductive type comprises:

an etching stop layer made of GaAs having a stripe-shaped current injection opening extending from one resonator end face to the other resonator end face, said etching stop layer being formed on said upper optical waveguide layer;
a current confinement layer of the first conductive type made of InGaAlP having a stripe-shaped current injection opening extending from one resonator end face to the other resonator end face, said current confinement layer being formed on said etching stop layer;
a cap layer of the first conductive type made of InGaP having a stripe-shaped current injection opening extending from one resonator end face to the other resonator end face, said cap layer being formed on said current confinement layer; and
a cladding layer of the second conductive type, being formed on said cap layer.

7. A semiconductor laser device according to claims 1, 3, 4, 5 or 6, wherein each of said cladding layers is made of any one of AlGaAs, InGaAlP and InGaAlAsP, which are lattice-matched with said GaAs substrate.

8. A semiconductor laser device according to claims 1 or 3, wherein said lower and upper barrier layers are respectively composed of $In_{x1}Ga_{1-x1}As_{1-y1}P_{y1}$ where $0\leq x1\leq0.3$ and $0\leq y1\leq0.6$

9. A semiconductor laser device according to claims 1 or 3, wherein said lower and upper barrier layers are respectively composed of two layers including a barrier layer made of $In_{x2}Ga_{1-x2}As_{1-y2}P_{y2}$ where $0\leq x2\leq0.3$ and $x2=0.49y2$ and a tensile strain barrier layer made of $In_{x4}Ga_{1-x4}As_{1-y4}P_{y4}$ where $0.49y4>x4\geq0$ and $0<y4\leq0.5$, wherein said tensile strain barrier layer of said two layers is disposed so as to be adjacent to said compressive strain active layer.

10. A method of manufacturing a semiconductor laser device in which a plurality of semiconductor layers including a compressive strain active layer are laminated on a substrate and a resonator end face is constituted by two opposite end faces, comprising the steps of:

laminating a cladding layer of a first conductive type on a GaAs substrate of a first conductive type;

forming an InGaP lower optical waveguide layer of the first conductive type or an undoped type on said cladding layer of the first conductive type, said lower optical waveguide layer having a band gap larger than that of said compressive strain active layer;

laminating an InGaAsP lower barrier layer on said lower optical waveguide layer, said lower barrier layer having a band gap larger than that of said compressive strain active layer;

laminating said compressive strain active layer made of any one of InGaAsP and InGaAs on said lower barrier layer;

laminating an InGaAsP upper barrier layer on said compressive strain active layer, said upper barrier layer having a band gap larger than that of said compressive strain active layer;

laminating an InGaP cap layer on said upper barrier layer;

laminating a GaAs cap layer on said cap layer, removing a portion on said GaAs cap layer in the vicinity of an end face adjacent to said resonator end face;

removing a portion of said InGaP cap layer in the vicinity of said end face using said GaAs cap layer as a mask;

removing said GaAs cap layer used as the mask and simultaneously removing portions of said upper barrier layer, said compressive strain active layer and said lower barrier layer in the vicinity of said end face, using said InGaP cap layer as a mask;

forming an InGaP upper optical waveguide layer of a second conductive type or an undoped type having a band gap larger than that of said compressive strain active layer on said removed portions in the vicinity of said end face and said InGaP cap layer; and

forming a cladding layer part of the second conductive type on said upper optical waveguide layer.

11. A method of manufacturing a semiconductor laser device according to claim 10, wherein said cladding layer part of the second conductive type is formed by the steps of:

laminating a first cladding layer of the second conductive type on said upper optical waveguide layer;

laminating an InGaP first etching stop layer of the second conductive type on said first cladding layer;

laminating a GaAs second etching stop layer on said first etching stop layer;

laminating an InGaAlP current confinement layer of the first conductive type on said second etching stop layer;

laminating an InGaP cap layer of the first conductive type on said current confinement layer;

laminating a second GaAs cap layer on said InGaP cap layer;

removing a portion of said second GaAs cap layer corresponding to a stripe-shaped current injection opening;

removing portions of said InGaP cap layer of the first conductive type and said current confinement layer, which are to be used as said current injection opening, using the second GaAs cap layer as a mask;

removing said second GaAs cap layer used as the mask and simultaneously removing a portion of said second etching stop layer, which is to be used as said current injection opening, using said InGaP cap layer of the first conductive type as a mask; and

forming a second cladding layer of the second conductive type so as to cover said current injection opening.

12. A method of manufacturing a semiconductor laser device according to claim 10, wherein said cladding layer part of the second conductive type is formed by the steps of:

laminating a GaAs etching stop layer on said upper optical waveguide layer;

laminating an InGaAlP current confinement layer of the first conductive type on said second etching stop layer;

laminating an InGaP cap layer of the first conductive type on said current confinement layer;

laminating a second GaAs cap layer on said InGaP cap layer;

removing a portion of said second GaAs cap layer corresponding to a stripe-shaped current injection opening;

removing portions of said InGaP cap layer of the first conductive type and said current confinement layer, which are to be used as said current injection opening, using said second GaAs cap layer as a mask;

removing said second GaAs cap layer used as the mask and simultaneously removing a portion of said GaAs etching stop layer, which is to be used as said current injection opening, using said InGaP cap layer of the first conductive type as a mask; and

forming a cladding layer of the second conductive type so as to cover said current injection opening.

13. A semiconductor laser device comprising:

a GaAs substrate of a first conductive type;

a lower cladding layer of said first conductive type, the lower cladding layer being formed on said GaAs substrate;

a lower optical waveguide layer of said first conductive type or an undoped type made of In-GaP, the lower optical waveguide layer being lattice-matched with said GaAs substrate and formed on said lower cladding layer;

an active layer made of $In_{x1}Ga_{1-x1}As_{1-y1}P_{y1}$ with compressive strain where $0<x1\leq0.4$ and $0\leq y1\leq0.1$, the active layer being formed on said lower optical waveguide layer;

an upper first optical waveguide layer of a second conductive type or an undoped type made of InGaP, the upper first optical waveguide layer being lattice-matched with said GaAs substrate and formed on said active layer;

a current confinement layer of a first conductive type made of $In_{0.49}(Al_{z2}Ga_{1-z2})_{0.51}P$, the current confinement layer having an opening serving as a current passage and being formed on said upper first optical waveguide layer;

an upper second optical waveguide layer of the second conductive type formed so as to bury said opening, the upper second optical waveguide layer being formed on said current confinement layer;

an upper cladding layer of the second conductive type, the upper cladding layer being formed on said upper second optical waveguide layer;

a GaAs contact layer of the second conductive type, the GaAs contact layer being formed on said upper cladding layer;

an electrode formed on said GaAs contact layer; and

resonator end faces formed of two opposite end faces,

wherein a current injection control structure that controls a current injection to said active layer is provided in the vicinity of at least one of said end faces.

14. A semiconductor laser device according to claim 13, wherein said current injection control structure is formed by providing said GaAs contact layer to extend inwardly from a position away from said one end face by 5 μm or more.

15. A semiconductor laser device according to claim 13, wherein said current injection control structure is formed by providing said GaAs contact layer to extend inwardly from a position away from said one end face by 5 μm or more, providing said electrode having a portion on said contact layer, the portion projecting to said end face from said contact layer, and providing an insulation layer between the projected portion of said electrode and said cladding layer of the second conductive type.

16. A semiconductor laser device according to claim 13,

wherein said active layer is laminated only inwardly from a position away from at least one of said end faces by a predetermined distance, and

a layer which has a band gap larger than that of said active layer, the layer being equivalent to said upper first optical waveguide layer, is laminated on a region ranging from an end edge of said active layer away from said end face to said end face.

17. A semiconductor laser device according to claim 13, wherein each of said cladding layers is made of any one of $Al_{z1}Ga_{1-z1}As$ where $0.57\leq z1\leq0.8$ and $In_{0.49}(Ga_{1-z4}Al_{z4})_{0.51}P$ where $0.1\leq z4\leq0.5$.

18. A semiconductor laser device according to claim 13, wherein said upper second optical waveguide layer of the second conductive type is made of any one of InGaP and AlGaAs having a refractive index equivalent to that of said InGap, which are lattice-matched with said GaAs substrate.

19. A semiconductor laser device according to claim 13, further comprising barrier layers with a thickness of 10mm or less made of $In_{x3}Ga_{1-x3}As_{1-y3}P_{y3}$ where $0\leq x3\leq0.3$ and $0.1\leq y3\leq0.6$, said barrier layers being severally formed between said active layer and said lower optical waveguide layer and between said active layer and said upper first optical waveguide layer and having band gaps larger than that of said active layer.

20. A semiconductor laser device according to claim 19, further comprising a strain compensation layer made of $In_{x2}Ga_{1-x2}As_{1-y2}P_{y2}$ where $0\leq x2<0.49y2$ and $0<y2\leq0.5$, said strain compensation layer being formed between said active layer and said barrier layer, and having tensile strain stress.

21. A semiconductor laser device according to claim 13, wherein an oscillation peak wavelength is in a range from 900 to 1200 nm.

22. A semiconductor laser device according to claim 13, wherein a width of said current passage is 1.5

μm or more and less than 4 μm, and a refractive index step difference is in a range from 1.5 $\times 10^{-3}$ to 7.0 $\times 10^{-3}$.

23. A semiconductor laser device according to claim 13, wherein a width of said current passage is 4 μm or more, and a refractive index step difference is 1.5 $\times 10^{-3}$ or more.

24. A semiconductor laser device comprising:

a GaAs substrate of a first conductive type;
a lower cladding layer of said first conductive type, the lower cladding layer being formed on said GaAs substrate;
a lower optical waveguide layer of said first conductive type or an undoped type made of In-GaP, the lower optical waveguide layer being lattice-matched with said GaAs substrate and formed on said lower cladding layer;
an active layer made of $In_{x1}Ga_{1-x1}As_{1-y1}P_{y1}$ with compressive strain where $0<x1\leq0.4$ and $0\leq y1\leq0.1$, the active layer being formed on said lower optical waveguide layer;
an upper first optical waveguide layer of a second conductive type or an undoped type made of InGaP, the upper first optical waveguide layer being lattice-matched with said GaAs substrate and formed on said active layer;
a current confinement layer made of $In_{0.49}(Al_{z2}Ga_{1-z2})_{0.51}P$ of a first conductive type, the current confinement layer having an opening serving as a current passage and being formed on said upper first optical waveguide layer;
an upper second optical waveguide layer of the second conductive type formed so as to bury said opening, the upper second optical waveguide layer being formed on said current confinement layer;
an upper cladding layer of the second conductive type, the upper cladding layer being formed on said upper second optical waveguide layer;
a GaAs contact layer of the second conductive type, the GaAs contact layer being formed on said upper cladding layer;
an electrode formed on said GaAs contact layer; and
resonator end faces formed of two opposite end faces,
wherein said active layer is laminated only inwardly from a position away from at least one of said end faces by a predetermined distance, and
a layer which has a band gap larger than that of said active layer, the layer being equivalent to said upper first optical waveguide layer, is laminated on a region ranging from an end edge of said active layer away from said end face to said end face.

25. A semiconductor laser device according to claim 24, wherein each of said cladding layers is made of any one of $Al_{z1}Ga_{1-z1}As$ where $0.57\leq z1\leq0.8$ and $In_{0.49}(Ga_{1-z4}Al_{z4})_{0.51}P$ where $0.1\leq z4\leq0.5$.

26. A semiconductor laser device according to claim 24, wherein said upper second optical waveguide layer of the second conductive type is made of any one of InGaP and AlGaAs having a refractive index equivalent to that of said InGaP, which are lattice-matched with said GaAs substrate.

27. A semiconductor laser device according to claim 24, further comprising barrier layers with a thickness of 10mm or less made of $In_{x3}Ga_{1-x3}As_{1-y3}P_{y3}$ where $0\leq x3\leq0.3$ and $0.1\leq y3\leq0.6$, said barrier layers being severally formed between said active layer and said lower optical waveguide layer and between said active layer and said upper first optical waveguide layer and having band gaps larger than that of said active layer.

28. A semiconductor laser device according to claim 27, further comprising a strain compensation layer made of $In_{x2}Ga_{1-x2}As_{1-y2}P_{y2}$ where $0\leq x2<0.49y2$ and $0<y2\leq0.5$, said strain compensation layer being formed between said active layer and said barrier layer, and having tensile strain stress.

29. A semiconductor laser device according to claim 24, wherein an oscillation peak wavelength is in a range from 900 to 1200 nm.

30. A semiconductor laser device according to claim 24, wherein a width of said current passage is 1.5 μm or more and less than 4 μm, and a refractive index step difference is in a range from 1.5 $\times 10^{-3}$ to 7.0 $\times 10^{-3}$.

31. A semiconductor laser device according to claim 24, wherein a width of said current passage is 4 μm or more, and a refractive index step difference is 1.5 $\times 10^{-3}$ or more.

# FIG.1A

# FIG.1B

# FIG.1C

# FIG.2A

→2C    →2B    116    117
119
115
110
109
108
107
106
105
104
103
102
101
118

→2C    →2B

# FIG.2B

117
116
115
113
112  111
110
109
108  107
106  105
104
103
102
101
118

# FIG.2C

117
119
115
113
112
111
110
109
108
103
102
101
118

# FIG.3A

3C        3B     139   138

137
132
131
130
129
128
127
126 125
124
123
122
121
140

3C        3B

# FIG.3B

139
138
137
135
134 133
132 131
130 129
128 127
126 125
124
123
122
121
140

# FIG.3C

139
138
137
135
134
133
132
131
130
123
122
121
140

# FIG.4A

4C
4B

155
154
153
148
147
146
145
144
143
142
141
156

4C
4B

# FIG.4B

155
154
153
151
150
149
148
147
146
145
144
143
142
141
156

# FIG.4C

155
154
153
151
150
149
148
143
142
141
156

# FIG.5A

# FIG.5B

# FIG.5C

# FIG.6A

6C    6B    174    172    171

168
167
166
165
164
163
162

161
175

6C    6B

# FIG.6B

172  171  174
173

168
167
166
165
164
163
162

161

175

# FIG.6C

172  171
174
173

168

163

162

161

175

# FIG.7A

→7B    →7C    237 236

235
234
232
230 231
228 229
226 227
225
224
223
222
221
238

→7B    →7C

# FIG.7B

235
234
232
231 230
229 228
227 226
225
224
223
222
221
238

# FIG.7C

237
236
235
234
232
231
230
229
228
227 226
225
224
223
222
221
238

# FIG.8A

239  →8B  →8C  237 236 239

235
234
232 231
230 229
228 227
226 225
224
223
222
221
238

→8B  →8C

# FIG.8B

237
239
235
234
232
231   230
229   228
227   226
225
224
223
222
221
238

# FIG.8C

237
236
235
234
232
231
230
229   228
227   226
225
224
223
222
221
238

# FIG.9A

9B    9C    237   236

235
234
232   231
230   229
228   227
226   225
224
223
222

221

238

9B    9C

# FIG.9B

237
236
235
234
232
231
230
229

223
222

221

238

# FIG.9C

237
236
235
234
232
231
230
229   228
227   226
225
224
223
222

221

238

# FIG.10A

10B    10C    237 236 239

239

235
234
232 231
230 229
228
226 227
225
224
223
222

221

238

10B    10C

# FIG.10B

237
239
235
234
232
231
230
229

223
222

221

238

# FIG.10C

237
236
235
234
232
231
230
229
227
225
224
223
222

221

238